(19) Europäisches Patentamt
European Patent Office
Office européen des brevets

(11) Veröffentlichungsnummer: **0 242 330**
**B1**

(12) **EUROPÄISCHE PATENTSCHRIFT**

(45) Veröffentlichungstag der Patentschrift: **16.05.90**

(51) Int. Cl.$^5$: **C 08 F 2/50,** G 03 F 7/028

(21) Anmeldenummer: **87810226.8**

(22) Anmeldetag: **09.04.87**

(54) **Flüssige Photoinitiatorgemische.**

(30) Priorität: **15.04.86 CH 1487/86**

(43) Veröffentlichungstag der Anmeldung:
**21.10.87 Patentblatt 87/43**

(45) Bekanntmachung des Hinweises auf die Patenterteilung:
**16.05.90 Patentblatt 90/20**

(84) Benannte Vertragsstaaten:
**AT BE CH DE ES FR GB IT LI NL SE**

(56) Entgegenhaltungen:
**EP-A-0 122 223**
**US-A-3 715 293**

(73) Patentinhaber: **CIBA-GEIGY AG**
**Klybeckstrasse 141**
**CH-4002 Basel (CH)**

(72) Erfinder: **Berner, Godwin, Dr.**
**Sommerhalde 5**
**CH-4102 Binningen (CH)**
Erfinder: **Sitek, Franciszek, Dr.**
**Grossmattweg 11**
**CH-4106 Therwil (CH)**
Erfinder: **Hüsler, Rinaldo, Dr.**
**Route du Confin52**
**CH-1723 Marly (CH)**

**EP 0 242 330 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

## Beschreibung

Die Erfindung betrifft flüssige Gemische von Photoinitiatoren. Es handelt sich dabei um Lösungen von Titanocenverbindungen in flüssigen Photoinitiatoren vom Ketaltyp. Die Erfindung betrifft weiterhin photohärtbare Zusammensetzungen, die solche flüssige Photoinitiatorgemische enthalten.

Titanocenverbindungen mit fluoraromatischen Resten sind aus der EP—A—122.223 als sehr wirksame Initiatoren für die Photopolymerisation ethylenisch ungesättigter Verbindungen bekannt. Die dort beschriebenen Verbindungen sind alle fest und in den üblichen photopolymerisierbaren Verbindungen bzw. Gemischen sehr schwer löslich. Es besteht ein Bedarf an leicht löslichen oder flüssigen Photoinitiatoren mit hoher Wirksamkeit. Es wurde nun gefunden, dass eine Kombination von Titanocen-Initiatoren mit flüssigen Photoinitiatoren vom Ketal- oder Acetaltyp zu flüssigen Initiatoren mit ausserordentlich hoher Wirksamkeit führt. Als flüssige Photoinitiatoren vom Acetal- oder Ketaltyp eignen sich besonders Benzilketale, 4-Aroyl-1,3-dioxolane sowie Dialkoxyacetophenone.

Photoinitiatoren vom Typ der Benzilketale sind bekannt aus der US—A—3,715,293, der DE—B—2,232,365, der GB—B—1,390,006 oder der EP—A—2707. Unter den dort beschriebenen Verbindungen finden sich sowohl feste wie flüssige Verbindungen. Erfindungsgemäss werden nur die flüssigen Ketale verwendet, wobei auch Ketale verwendet werden, die bisher noch nicht bekannt waren.

Photoinitiatoren vom Typ der 4-Aroyl-1,3-dioxolane sind bekannt aus der EP—A—108,037. Die meisten dieser Verbindungen sind flüssig.

Photoinitiatoren vom Typ der α-Dialkoxyacetophenone sind bekannt aus der US—A—3,715,293.

Die meisten dieser Verbindungen sind ebenfalls flüssig.

Die Erfindung betrifft flüssige Photoiniatorgemische, bestehend aus

A) 70—99,9 Gew.-% mindestens eines flüssigen Acetal- oder Ketal- Photoinitiators ausgewählt aus

$A_1$) einer Verbindung der Formel I,

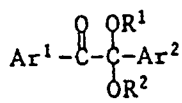

I

worin

$Ar^1$ und $Ar^2$ unabhängig voneinander Phenyl oder durch $C_1$—$C_4$-Alkyl oder Halogen substituiertes Phenyl sind,

$R^1$ $C_4$—$C_{20}$-Alkyl, $C_3$—$C_{18}$-Alkenyl, $C_7$—$C_{10}$-Phenylalkyl, eine Gruppe —$CH(R^3)$—$COOR^4$, —$R^5$—X, $-[CH(R^3)-CH(R^{10})]_mO$ ]30—$R^6$ oder Tetrahydrofurfuryl darstellt, worin

$R^3$ und $R^{10}$ unabhängig voneinander Wasserstoff oder Methyl sind,

$R^4$ $C_1$—$C_{20}$-Alkyl, $C_3$—$C_5$-Alkenyl oder $C_3$—$C_8$-Alkoxyalkyl ist

$R^5$ $C_2$—$C_{10}$-Alkylen bedeutet,

X Halogen, —$COOR^4$, —$OR^4$ oder —$NR^7R^8$ bedeutet, wobei $R^7$ $C_1$—$C_{12}$-Alkyl, Allyl, Benzyl, Cyclohexyl, $C_2$—$C_4$-Hydroxyalkyl oder $C_3$—$C_8$-Alkoxyalkyl bedeutet, $R^8$ Wasserstoff ist oder eine der für $R^7$ gegebenen Bedeutungen hat oder $R^7$ und $R^8$ zusammen, $C_3$—$C_7$-Alkylen bedeuten, das durch O, S oder $NR^9$ unterbrochen sein kann und $R^9$ $C_1$—$C_4$-Alkyl, $C_2$—$C_4$-Hydroxyalkyl oder 2-Cyanoethyl bedeutet,

m ein Wert von 1 bis 30 ist und

$R_6$ $C_1$—$C_{20}$-Alkyl, $C_3$—$C_5$-Alkenyl, $C_3$—$C_8$-Alkoxyalkyl, $C_7$-$C_{22}$-Alkylphenyl oder $C_2$—$C_{20}$-Alkanoyl bedeutet, und

$R^2$ $C_1$—$C_3$-Alkyl ist oder eine der für $R^1$ angegebenen Bedeutungen hat oder

$A_2$) einer Verbindung der Formel II,

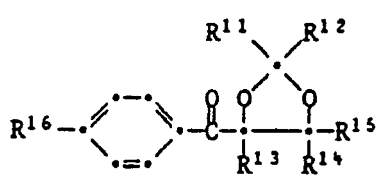

II

worin

$R^{11}$ Wasserstoff, unsubstituiertes oder durch Hydroxy oder $C_1$—$C_4$-Alkoxy substituiertes $C_1$—$C_{10}$-Alkyl oder $C_7$—$C_{10}$-Phenylalkyl bedeutet,

$R^{12}$ Phenyl, 2-Furyl oder Trichlormethyl ist oder eine der für $R^{11}$ gegebenen Bedeutungen hat, oder $R^{11}$ und $R^{12}$ zusammen mit dem C-Atom, an das sie gebunden sind, einen Cyclopentan- oder Cyclohexanring bilden,

$R^{13}$ $C_1$—$_4$-Alkyl, Phenyl oder durch eine oder mehrere Reste Cl, $C_1$—$C_4$-Alkyl oder $C_1$—$C_4$-Alkoxy substituiertes Phenyl bedeutet,

$R^{14}$ Wasserstoff oder $C_1$—$C_4$-Alkyl bedeutet,

$R^{15}$ Wasserstoff, $C_1$—$C_4$-Alkyl, Phenyl oder Trichlormethyl bedeutet,

$R^{16}$ Wasserstoff, Chlor, $C_1$—$C_4$-Alkyl oder, $C_1$—$C_4$-Alkoxy bedeutet, oder

$A_3$) einer Verbindung der Formel III,

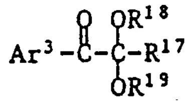

III

worin

$Ar^3$ Phenyl oder durch $C_1$—$C_4$-Alkyl oder Halogen substituiertes Phenyl ist,
$R^{17}$ Wasserstoff, $C_1$—$C_8$-Alkyl oder $C_5$—$C_8$-Cycloalkyl ist,
$R^{18}$ $C_1$—$C_8$-Alkyl oder $C_3$—$C_8$-Alkoxyalkyl ist und
$R^{19}$ eine für $R^{18}$ gegebenen Bedeutungen hat, und

B) 0,1—30 Gew.-% eines Titanocen-Photoinitiators, ausgewählt aus

$B_1$) einer Verbindung der Formel IV

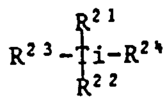

IV

worin

$R^{21}$ und $R^{22}$ unabhängig voneinander ein unsubstituiertes oder durch $C_1$—$C_4$-Alkyl, Chlor, Phenyl oder Cyclohexyl substituiertes Cyclopentadienyl- oder Indenyl-Anion bedeuten oder $R^{21}$ und $R^{22}$ zusammen ein zweiwertiges Bis-cyclopentadienyl-Anion der Formel V bedeuten,

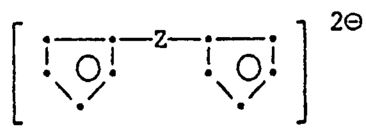

V

worin

Z Methylen, Di- oder Trimethylen, $C_2$—$C_{12}$-Alkyliden, $C_5$—$C_7$-Cycloalkyliden, —Si($R^{25}$)($R^{26}$)- oder —Sn($R^{25}$)$_2$- bedeutet und

$R^{25}$ und $R^{26}$ $C_1$—$C_{12}$-Alkyl, Phenyl oder Benzyl bedeuten,

$R^{23}$ den einwertigen Rest eines 6-gliedrigen carbocyclischen oder 5-oder 6-gliedrigen heterocyclischen aromatischen Ringes bedeutet, der in mindestens einer ortho-Position zur Bindung an das Ti-Atom durch Fluor substituiert ist und ausserdem durch eine oder mehrere der Gruppen Halogen, $C_1$—$C_{12}$-Alkyl, $C_1$—$C_{14}$-Alkoxy, $C_2$—$C_{10}$-Alkoxyycarbonyl, Aminocarbonyl mit bis zu 12 C-Atomen oder durch eine primäre, sekundäre oder tertiäre Amino- oder Aminoalkylgruppe mit bis zu 20 C-Atomen oder eine quartäre Ammonium- oder Amoniumalkylgruppe mit bis zu 30 C-Atomen substituiert sein kann,

$R^{24}$ eine der für $R^{23}$ angegebenen Bedeutungen hat oder $C_2$—$C_{12}$-Alkinyl, unsubstituiertes oder im Phenylrest durch Halogen oder $C_1$—$C_4$-Alkyl, $C_1$—$C_{14}$-Alkoxy, Di-($C_2$—$C_4$-alkyl)-amino oder eine quartäre Ammoniumgruppe substituiertes Phenylalkinyl mit 2—5 C-Atomen im Alkinrest oder eine Gruppe —$N_3$, —CN, —Si($R^{25}$)$_3$, —Si($R^{25}$)$_2$($R^{26}$) oder —Sn($R^{25}$)$_3$ bedeutet, oder

$R^{23}$ und $R^{24}$ zusammen einen Rest der Formel VI bedeuten,

$$—Q—Y—Q— \qquad VI$$

worin

Q ein carbocyclischer oder 5- oder 6-gliedriger heterocyclischer aromatischer Ring ist, der in 2-Stellung zur Y-Gruppe an das Titan-Atom begunden ist und in 3-Stellung durch Fluor substituiert ist und als weitere Substituenten $C_1$—$C_{14}$-Alkyl, Halogen. $C_1$—$_4$-Alkoxy, Di($C_1$—$C_4$-alkyl)amino oder eine quartäre $C_3$—$C_{20}$-Ammoniumgruppe enthalten kann,

Y Methylen, $C_2$—$C_{12}$-Alkyliden, $C_5$—$C_7$-Cycloalkyliden, eine direkte Bindung oder eine Gruppe —$NR^{27}$—, —O—, —S—, —SO—, —$SO_2$—, —CO—, —Si($R^{25}$)($R^{26}$)- oder —Sn($R^{25}$)$_2$- bedeutet und $R^{27}$ Wasserstoff, $C_1$—$C_{12}$-Alkyl, Cyclohexyl, Phenyl, Tolyl oder Benzyl bedeutet, oder

$B_2$) einer Verbindung der Formel VII,

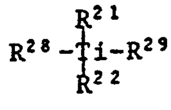

VII

worin

$R^{21}$ und $R^{22}$ die oben genannte Bedeutung haben,

$R^{28}$ den einwertigen Rest eines 6-gliedrigen carbocyclischen oder 5-oder 6-gliedrigen heterocyclischen aromatischen Ringes bedeutet, der mindestens einer ortho-Position zur Bindung an das Ti-Atom durch $-CF_3$, substituiert ist und ausserdem durch eine oder mehrere der Gruppen Halogen, $C_1$—$C_{12}$-Alkyl, $C_1$—$C_{14}$-Alkoxyy, $C_2$—$C_{10}$-Alkoxycarbonyl oder Aminocarbonyl oder durch eine primäre, sekundäre oder tertiäre Amino- oder Aminoalkylgruppe mit bis zu 20 C-Atomen oder eine quartäre Ammonium- oder Ammoniumalkylgruppe mit bis zu 30 C-Atomen substituiert sein kann, und

$R^{29}$ eine der für $R^{28}$ gegebenen Bedeutungen hat oder $C_2$—$C_{12}$-Alkinyl, unsubstituiertes oder im Phenylrest durch Halogen oder $C_1$—$C_4$-Alkyl substituiertes Phenylalkinyl mit 2—5 C-Atomen im Alkinrest oder Halogen oder eine Gruppe $-Si(R^{25})_3$, $-Si(R^{25})_2(R^{26})$, $-Sn(R^{25})_3$, —OH, $C_1$—$C_{10}$-Alkoxy, $C_6$—$C_{10}$-Aryloxy, unsubstituiertes oder mit Halogen substituiertes $C_1$—$C_6$-Acyloxy, $-N_3$, —CN. —NCO oder —NCS bedeutet.

Wenn in Formel I $R^1$ oder $R^2$ $C_4$—$C_{20}$-Alkyl bedeutet, so kann dies unverzweigtes oder verzweigtes Alkyl sein, wie z.B. n-Butyl, iso-Butyl, iso-Pentyl, n-Hexyl, 2-Ethylbutyl, iso-Heptyl, n-Octyl, 2-Ethylhexyl, n-Decyl, n-Dodecyl, Tetradecyl, Hexadecyl, Octadecyl oder Eicosyl. Bevorzugt ist $R^1$ als Alkyl ein Alkylrest mit 4—18 insbesondere 4—16 C-Atomen.

$R^4$ und $R^6$ als $C_1$—$C_{20}$-Alkyl können dieselben Bedeutungen wie $R^1$ oder $R^2$ haben, darüber hinaus aber auch Methyl, Ethyl, n-Propyl oder iso-Propyl sein.

$R^1$, $R^2$, $R^4$ und $R^6$ als $C_3$—$C_5$-Alkenyl können z.B. Alkyl, Methallyl, 2-Butenyl oder 2-Methyl-2-butenyl sein.

$R^1$ und $R^2$ als $C_3$—$C_{18}$-Alkenyl können darüber hinaus auch z.B. 2-Hexenyl, 2-Octenyl oder Oleyl sein.

$R^4$ und $R^6$ als $C_3$—$C_8$-Alkoxyalkyl können z.B. 2-Methoxyethyl, 2-Ethoxyethyl, 2-Butoxyethyl, 2-Ixohexyloxyethyl, 2-Ethoxypropyl, 2-Isopropoxypropyl oder 2-Ethoxybutyl sein.

$R^1$ und $R^2$ als $C_7$—$C_{10}$-Phenylalkyl können z.B. Benzyl, 1-Phenylethyl, 2-Phenylethyl, 2-Phenylpropyl oder 2-Phenylbutyl sein.

$R^6$ als $C_7$—$C_{22}$-Alkylphenyl kann z.B. 3-Methylphenyl, 3,5-Dimethylphenyl, 4-Isopropylphenyl, 4-tert.Butylphenyl, 4-Octylphenyl, 2,4-Dioctylphenyl, 4-Nonylphenyl, 4-Decylphenyl, 4-Dodecylphenyl oder 3-Pentadecylphenyl sein.

$R^6$ als $C_2$—$C_{20}$-Alkanoyl kann z.B. Acetyl, Propionyl, Butyryl, Hexanoyl, Octanoyl, Decanoyl, Lauroyl, Stearoyl oder Eikosanoyl sein.

X als Halogen kann z.B. Cl oder Br sein. X als Aminrest $-NR^7R^8$ kann z.B. Ethylamino, Dodecylamino, Dimethylamino, Dibutylamino, N-Methyl-butylamino, Di(2-ethylbutyl)amino, Di(2-hydroxyethyl)amino, Di(2-methoxyethyl)amino, Allylamino, Diallylamino, N-Methyl-benzylamino, N-Methyl-cyclohexylamino, N-Hydroxyethyl-cyclohexylamino, Di(2-butoxyethyl)amino, Pyrrolidino, Piperidino, Morpholino, Piperazino, 4-Methylpiperazino, 4-Hydroxyethylpiperazino oder 4-Cyanethylpiperazino sein.

$R^5$ kann unverzweigtes oder verzweigtes $C_2$—$C_{10}$-Alkylen sein, wie z.B. 1,2-Ethylen, Trimethylen, Tetramethylen, Hexamethylen, Octamethylen, 1,2-Propylen, 2,2-Dimethyltrimethylen oder 2,4,4-Trimethylhexamethylen. Vorzugsweise ist $R^5$ $C_2$—$C_4$-Alkylen, insbesondere 1,2-Ethylen.

Wenn $R_1$ ein Rest $-[CH(R^3)-CH(R^{10})-O]_m-R^6$ ist, so handelt es sich um Reste von oxyalkylierten Alkoholen, Alkylphenolen oder Fettsäuren. Diese Reste können von einheitlichen Verbindungen stammen, z.B. wenn m klein ist und $R^6$ niedrig ist. Wenn jedoch m grösser ist und $R^6$ ein höherer Alkylrest oder Alkylphenylrest ist, so sind diese oxyalkylierten Verbindungen meist nur als Gemische erhältlich. In diesen technischen Gemischen können sowohl Verbindungen mit unterschiedlichem m als auch mit unterschiedlichem $R^6$ vorliegen. Bei Verwendung solcher technischer Gemische zur Herstellung der Ketale der Formel I erhält man entsprechende Ketalgemische, in denen m und $R^6$ nur als Durchschnittswert definiert werden können.

Bevorzugt ist $R^1$ $C_4$—$C_{18}$-Alkyl, $C_3$—$C_5$-Alkenyl, $-CH_2COOR^4$, $-R^5X$, $-[CH(R^3)-CH_2O]_m-R^6$ oder Tetrahydrofuryl, wobei $R^3$ H oder $CH_3$ ist, $R^4$ $C_1$—$C_{18}$-Alkyl, Allyl oder $C_3$—$C_6$-Alkoxyalkyl ist, $R^5$ $C_2$—$C_4$-Alkylen ist, X Halogen, $-COOR^4$, $-OR^4$ oder eine tertiäre Aminogruppe mit 2—12 C-Atomen bedeutet, m 1—25 und $R^6$ $C_1$—$C_{18}$-Alkyl oder $C_{12}$—$C_{22}$-Alkylphenyl bedeutet.

Besonders bevorzugt ist $R^1$ ist $R^1$ $C_4$—$C_{16}$-Alkyl, $-CH_2COO(C_1$—$C_4$-Alkyl), $-CH_2CH_2X$ oder $-[CHCH_2O]_m-R_6$, wobei X Chlor, $C_1$—$C_8$-Alkoxy oder eine teriäre Aminogruppe mit 2—8 C-Atomen bedeutet, m ein Wert von 2—20 ist und $R^6$ $C_8$—$C_{16}$-Alkyl oder $C_{13}$—$C_{16}$-Alkylphenyl ist.

Als tertiäre Aminogruppe kann X eine offenkettige oder cyclische Aminogruppe sein, wie z.B. Dimethylamino, N-Methyl-cyclohexylamino, Morpholino oder Piperidino.

$R^2$ ist bevorzugt Methyl oder hat eine der für $R^1$ gegebenen Bedeutungen.

Biespiele für Verbindungen der Formel I, die flüssig sind und als Komponente A für die erfindungsgemässen Gemische verwendet werden können, sind die Benzilketale der folgenden Formel

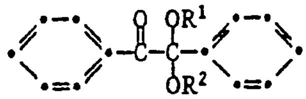

$R^1 = R^2 = -(CH_2)_3CH_3$

$-CH_2CH_2CH(CH_3)_2$

$-CH_2-\underset{C_2H_5}{CH}-C_4H_9$

$-(CH_2)_9CH_3$

$-C_{10}H_{21}$-iso

$-C_{12}H_{25}$-n

$-C_{14}H_{29}$

$-C_9H_{19}$ bis $-C_{11}H_{23}$-Gemisch

$-C_{12}$-$H_{25}$-bis-$C_{15}H_{31}$-Gemisch

$-CH_2CH{=}CH_2$

$-CH(CH_3)CH{=}CH_2$

$-CH_2CH_2OC_3H_7$-iso

$-CH_2CH_2OC_4H_9$

$-CH_2CH_2OCH_2CH{=}CH_2$

$-CH(CH_3)-CH_2OC_4H_9$

$-CH_2COOCH_3$

$-CH_2COOC_4H_9$

$-CH(CH_3)COOCH_3$

$-CH_2CH_2COOC_2H_5$

$-CH(CH_3)CH_2COOCH_3$

$-CH_2CH_2CH(CH_3)OCH_3$

$-CH_2-$ 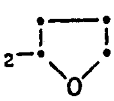

$-(CH_2CH_2O)_2CH_3$

$-(CH_2CH_2O)_2C_2H_5$

$-(CH_2CH_2O)_2C_4H_9$

$-(CH_2CH_2O)_3CH_3$

$-(CH_2CH_2O)_3C_2H_5$

$-(CH_2CH_2O)_3C_{12}H_{25}$

$-(CH_2CH_2O)_3C_{10}H_{21}$

$-(CH_2CH_2O)_5C_9H_{19}$-bis $-C_{11}H_{23}$ (Gemisch)

$-(CH_2CH_2O)_3-C_{12}H_{25}$ bis $C_{15}-C_{31}$ (Gemisch)

$-(CH_2CH_2O)_5-C_{10}H_{21}$

$-(CH_2CH_2O)_5-C_9H_{19}$ bis $-C_{11}H_{23}$ (Gemisch)

$-(CH_2CH_2O)_7-C_{12}H_{25}$ bis $-C_{15}H_{31}$ (Gemisch)

$-(CH_2CH_2O)_8-C_{10}H_{21}$

$-(CH_2CH_2O)_{11}-C_{14}H_{29}$

$-(CH_2CH_2O)_5-$ 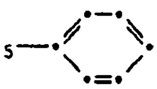 $-C_8H_{17}$

$-(CH_2CH_2O)_5-$ 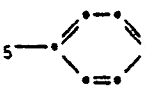 $-C_9H_{19}$

$-(CH_2CH_2O)_{12}-$ 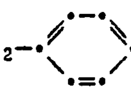 $-C_9H_{19}$

$-(CH_2CH_2O)_8-CO-C_{11}H_{23}$

$-(CH_2CH_2O)_2-$ 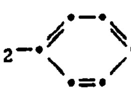 $-C_8H_{17}$

$-CH_2CH_2N(C_2H_5)_2$

$-CH_2CH_2-$ 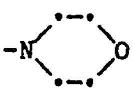

$-CH_2CH_2-$ 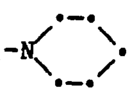

$-CH_2CH_2-$ 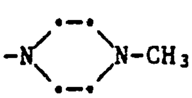

$R^2 = CH_3$, $R^1 = C_6H_{13}$

$R^2 = CH_3$, $R^1 = C_{10}H_{21}$

$R^2 = CH_3$, $R^1 = -(CH_2CH_2O)_3-C_9H_{19}$ bis $-C_{11}H_{23}$ (Gemisch)

$R^2 = CH_3$, $R^1 = -(CH_2CH_2O)_5-C_9H_{19}$ bis $-C_{11}H_{23}$ (Gemisch)

$R^2 = CH_3$, $R^1 = -C_{14}H_{29}$

$R^2 = CH_3$, $R^1 = -C_9H_{19}$ bis $C_{11}H_{23}$ (Gemisch)

$R^2 = CH_3$, $R^1 = -C_{12}H_{25}$ bis $-C_{15}H_{31}$ (Gemisch)

$R^2 = C_2H_5$, $R^1 = -(CH_2CH_2O)_3-C_{12}H_{25}$ bis $-C_{15}H_{31}$ (Gemisch)

$R^2 = CH_3$, $R^1 = -(CH_2CH_2O)_5-C_{12}H_{25}$ bis $-C_{15}H_{31}$ (Gemisch)

$R^2 = CH_3$, $R^1 = -(CH_2CH_2O)_9-C_{12}H_{25}$ bis $-C_{15}H_{31}$ (Gemisch)

$R^2 = CH_3$, $R^1 = -(CH_2CH_2O)_5-$ 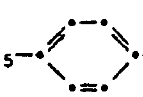 $-C_8H_{17}$

$R^2 = CH_3$, $R^1 = -(CH_2CH_2O)_5-$ 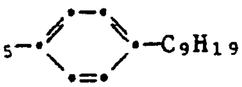

$R^2 = CH_3$, $R^1 = -(CH_2CH_2O)_3-CO-C_{11}H_{23}$

$R^2 = CH_3$, $R^1 = -(CH_2CH_2O)_8-\overset{O}{\overset{\|}{C}}-C_{11}H_{23}$

In Formel II können $R^{11}$, $R^{12}$, $R^{13}$, $R^{14}$, $R^{15}$ und $R^{16}$ $C_1$—$C_4$-Alkyl bedeuten, beispielsweise Methyl, Ethyl, n-Propyl, iso-Propyl, n-Butyl oder iso-Butyl. $R^{11}$ und $R^{12}$ können darüber hinaus auch $C_5$—$C_{10}$-Alkyl sein, wie z.B. Pentyl, Hexyl, Octyl oder Decyl. $R^{11}$ und $R^{12}$ als Alkoxyalkyl können z.B. Ethoxymethyl, 2-Methoxyethyl, 2-Butoxypropyl oder 2-Isopropoxybutyl sein. $R^{11}$ und $R^{12}$ als Phenylalkyl können z.B. Benzyl, 1-Phenylethyl, 2-Phenylethyl oder 3-Phenylpropyl sein.

Beispiele für flüssige Verbindungen der Formel II sind:
4-Benzoyl-2,2,4-trimethyl-1,3-dioxolan
4-Benzoyl-4-methyl-2,2-tetramethylen-1,3-dioxolan
4-Benzoyl-4-methyl-2,2-pentamethylen-1,3-dioxolan
cis-trans 4-Benzoyl-2,4-dimethyl-2-methoxymethyl-1,3-dioxolan
cis-trans 4-Benzoyl-4-methyl-2-phenyl-1,3-dioxolan
4-(4-Methoxybenzoyl)-2,2,4-trimethyl-1,3-dioxolan
4-(4-Methoxybenzoyl)-4-methyl-2,2-pentamethylen-1,3-dioxolan
4-(4-Methylbenzoyl)-2,2,4-trimethyl-1,3-dioxolan
cis-trans 4-Benzoyl-2-methyl-4-phenyl-1,3-dioxolan
4-Benzoyl-2,2,4,5,5-pentamethyl-1,3-dioxolan
cis-trans 4-Benzoyl-2,2,4,5-tetramethyl-1,3-dioxolan
cis-trans 4-Benzoyl-4-methyl-2-pentyl-1,3-dioxolan
cis-trans 4-Benzoyl-2-benzyl-2,4-dimethyl-1,3-dioxolan
cis-trans 4-Benzoyl-2-(2-furyl)-4-methyl-1,3-dioxolan
cis-trans 4-Benzoyl-5-phenyl-2,2,4-trimethyl-1,3-dioxolan
4-(4-Methoxybenzoyl)-2,2,4,5,5-pentamethyl-1,3-dioxolan

In den Verbindungen der Formel III kann $Ar^3$ Phenyl oder substituiertes Phenyl sein, wie z.B. 4-Chlorophenyl, 4-Fluorphenyl, 4-Tolyl, 2,4-Xylyl, oder 4-tert.Butylphenyl.

$R^{17}$, $R^{18}$ und $R^{19}$ können als $C_1$—$C_8$-Alkyl unverzweigt oder verzweigt sein wie z.B. Methyl, Ethyl, n-Propyl, n-Butyl, Isobutyl, n-Amyl, n-Hexyl, 2-Ethylbutyl, Isoheptyl, n-Octyl oder 2-Ethylhexyl. $R^{17}$ als $C_5$—$C_8$-Cycloalkyl kann z.B. Cyclopentyl, Cyclohexyl, Methylcyclohexyl oder Cyclooctyl sein. $R^{18}$ und $R^{19}$ als $C_3$—$C_8$-Alkoxyalkyl können z.B. 2-Methoxyethyl, 2-Butoxyethyl, 2-Hexyloxyethyl, 3-Methoxypropyl oder 2-Ethoxypropyl sein.

Bevorzugt sind $Ar^3$ Phenyl, $R^{17}$ Wasserstoff und $R^{18}$ und $R^{19}$ $C_1$—$C_4$-Alkyl.

Beispiele für flüssige Verbindungen der Formel III sind:
α,α-Dimethoxyacetophenon
α,α-Diethoxyacetophenon
α,α-Di-isopropoxyacetophenon
α,α-Di-(2-methoxyethoxy)acetophenon
α-Butoxy-α-ethoxyacetophenon
α,α-Dibutoxy-4-chloracetophenon
α,α-Diethoxy-4-fluoracetophenon
α,α-Dimethoxy-4-methylacetophenon
α,α-Dimethoxy-4-methylacetophenon
α,α-Dimethoxypropiophenon
α,α-Diethoxypropiophenon
α,α-Diethoxybutyrophenon
α,α-Dimethoxyisovalerophenon
α,α-Diethoxy-α-cyclohexylacetophenon
α,α-Dipropoxy-4-chlorpropiophenon

In den Verbindungen der Formel IV und VII ist das Titan-Atom an zwei π-Anionen vom Cyclopentadienyltyp gebunden. Die beiden Anionen können untereinander über die Brücke Z kovalent verknüpft sein, wodurch ein Ligand der Formel V entsteht.

Beispiele für solche Gruppen Z sind $-CH_2-$, $-CH_2CH_2-$, 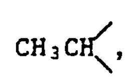,

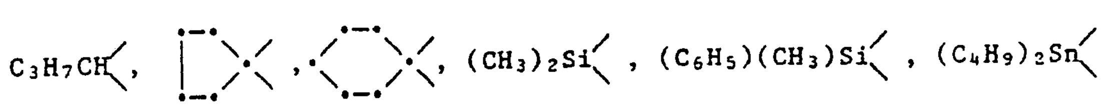

oder $(C_8H_{17})_2Sn<$. Bevorzugt ist 2 eine Methylengruppe.

In den Verbindungen der Formel IV ist das Titan ausserdem an mindestens einen aromatischen Rest $R^{23}$ kovalent gebunden. Der aromatische Rest kann carbocyclisch oder heterocyclisch sein und muss in Orthostellung zur C—Ti—Bindung durch Fluor substituiert sein. Beispiele für solche aromatische Reste sind fluorierte Benzole, Naphthaline, Furane, Thiophene, Pyrrole, Pyridine, Pyrimidine, Pyrazole, Imidazole, Oxazole oder Thiazole, die ausserdem noch andere Substituenten tragen können wie Halogenatome, Alkyl- oder Alkoxygruppen, Alkoxycarbonyl- oder Aminocarbonylgruppen, Aminogruppen oder Aminoalkylgruppen sowie deren Quaternierungsprodukte. Beispiele für solche Substituenten sind Fluor, Chlor, Brom, Methyl, Ethyl, iso-Propyl, tert.-Butyl, n-Nonyl oder n-Dodecyl, Methoxy, Ethoxy, Butoxy, Octyloxy, Decyloxy, Dodecyloxy, Methoxycarbonyl, Ethoxycarbonyl, Butoxycarbonyl, 2-Ethylhexyloxy oder n-Decyloxy, Aminocarbonyl, Butylaminocarbonyl, Diethylaminocarbonyl oder Pyrrolidinocarbonyl, $—NH_2$, $—NHC_4H_9$, $—N(CH_3)_2$, $—N(CH_3)_3^{\oplus}Cl^{\ominus}$, Morpholino, Piperidino, $—CH_2NH_2$, $—CH_2N(C_2H_5)_2$, $—CH_2N(C_2H_5)_3^{\oplus}Br^{\ominus}$ oder Pyrrolidinomethyl

Bevorzugt ist $R^{23}$ win Benzolrest, der in beiden Orthostellungen durch Fluor substituiert ist.

$R^{24}$ kann ebenfalls ein einwertiger fluor-aromatischer Rest sein oder ist Alkinyl- oder Phenylalkinylgruppe, die im Phenylrest entsprechend substituiert sein kann, oder $R^{24}$ ist ein Azido-, Cyano-, Triorganosilyl- oder Triorganostannyl-Rest.

Wenn $R^{24}$ Alkinyl ist, so kann es z.B. Ethinyl, 1-Propinyl, 1-Butinyl, 2-Hexinyl, 1-Octinyl, 1-Decinyl oder 1-Dodecinyl sein. $R^{24}$ als unsubstituiertes oder substituiertes Phenylalkinyl kann z.B. 2-Phenylethinyl, 3-Phenylpropinyl, 3-Phenylbutinyl, 2-(4-Chlorphenyl)-ethinyl oder 3-(4-Tolyl)-propinyl sein.

$R^{24}$ als Triorganosilyl- oder Triorganostannylrest kann z.B. Trimethylsilyl, Triphenylsilyl, Dimethylphenyl-silyl, Methyl-di-phenylsilyl, Tributylsilyl, Trimethylstannyl, Tributylstannyl, Trioctylstannyl oder Tri(dodecyl)stannyl sein.

$R^{23}$ und $R^{24}$ können verknüpft sein zu einem zweiwertigen aromatischen Rest der Formel VI. Darin sind Q carbocyclische oder heterocyclische Reste, die in 2-Stellung zur Verknüpfung Y an das Titanatom gebunden sind und in 3-Stellung durch Fluor substituiert sind. Beispiele für solche zweiwertige Gruppen sind die folgenden Gruppen, worin E —O—, —S— oder —NH— bedeutet:

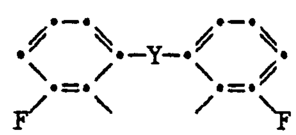
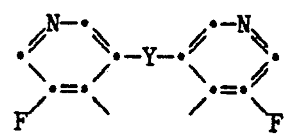
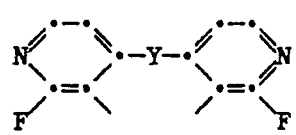
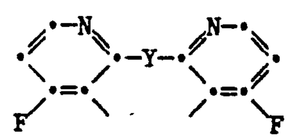
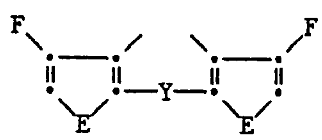
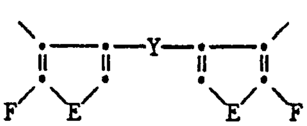

Die aromatischen Reste Q können weitere Substituenten tragen insbesondere Halogen, Methyl und Dimethylamino. Das Brückenglied Y kann eine direkt Bindung, ein zweiwertiges Atom oder eine zweiwertige Gruppe sein. Bevorzugt ist Y $—CH_2—$,

$CH_3CH<$ , $C_2H_5CH<$ ,

—S—, —O— oder eine direkte Bindung.

Bevorzugt sind $R^{23}$ und $R^{24}$ gleich und sind ein substituierter Phenylrest, insbesondere ein 2,6-Difluorphenylrest, der noch weitere Substituenten tragen kann.

Beispiele für Verbingungen der Formel IV sind:

Bis(cyclopentadienyl)-bis(pentafluorphenyl)-titan
Bis(cyclopentadienyl)-bis(3-brom-3-tetrafluorphenyl)-titan
Bis(cyclopentadienyl)-bis(4-brom-tetrafluorphenyl)-titan
Bis(cyclopentadienyl)-bis(2,4,5,6-tetrafluorphenyl)-titan
Bis(cyclopentadienyl)-bis(3,5-dichlor-2,4,6-trifluorphenyl)-titan
Bis(cyclopentadienyl)-bis(4-morpholino-tetrafluorphenyl)-titan
Bis(cyclopentadienyl)-bis(4-[4'methylpiperazino]-tetrafluorphenyl)-titan
Bis(cyclopentadienyl)-bis(4-dibutyllamino-tetrafluorphenyl)-titan

Bis(cyclopentadienyl)-bis(2,4,6-trifluorphenyl)-titan
Bis(methylcyclopentadienyl)-bis(pentafluorphenyl)-titan
Bis(methylcyclopentadienyl)-bis(4-morpholino-tetrafluorphenyl)-titan
Bis(methylcyclopentadienyl)-bis(4-[4'-methylpiperazino]-tetrafluorphenyl)-titan
Bis(cyclopentadienyl)-bis(4-[dimethylaminomethyl]-tetrafluorphenyl)-titan
Bis(cyclopentadienyl)-bis(2,3,5,6-tetrafluorphenyl)-titan
Bis(methylcyclopentadienyl)-bis(2,3,5,6-tetrafluorphenyl)-titan
Bis(methylcyclopentadienyl)-bis(2,4,6-trifluorphenyl)-titan
Bis(cyclopentadienyl)-bis(2,3,6-trifluorphenyl)-titan
Bis(methylcyclopentadienyl)-bis(2,6-difluorphenyl)-titan
Bis(cyclopentadienyl)-bis(2,6-difluor-3-methylphenyl)-titan
Bis(cyclopentadienyl)-bis(4-dibutylamino-tetrafluorphenyl)-titan
Bis(cyclopentadienyl)-bis(4-methoxy-tetrafluorphenyl)-titan
Bis(cyclopentadienyl)-bis(4-butoxy-tetrafluorphenyl)-titan
Bis(cyclopentadienyl)-bis(4-isopropoxy-tetrafluorphenyl)-titan
Bis(cyclopentadienyl)-bis[4-(2-ethylhexyloxy)-tetrafluorphenyl]-titan
Bis(cyclopentadienyl)-bis(4-decyloxy-tetrafluorphenyl)-titan
Bis(cyclopentadienyl)-bis(4-octyloxy-tetrafluorphenyl)-titan
Bis(methylcyclopentadienyl)-bis(2,6-fluor-3-methylphenyl)-titan
Bis(methylcyclopentadienyl)-bis(4-octyloxy-tetrafluorphenyl)-titan
Bis(methylcyclopentadienyl)-bis(4-decyloxy-tetrafluorphenyl)-titan
Bis(methylcyclopentadienyl)-bis(4-dedocyloxy-tetrafluorphenyl)-titan
Bis(methylcyclopentadienyl)-bis(4-butoxy-tetrafluorphenyl)-titan
Bis(methylcyclopentadienyl)-bis(4-ethoxy-tetrafluorphenyl)-titan
Bis(methylcyclopentadienyl)-bis(4-isopropoxy-tetrafluorphenyl)-titan
Bis(methylcyclopentadienyl)-bis(4-dibutylamino-tetrafluorphenyl)-titan
Bis(cyclopentadienyl)-bis(2,6-difluorphenyl)-titan
Bis(cyclopentadienyl)-bis(2,4,5-trifluorphenyl)-titan
Bis(cyclopentadienyl)-bis(2,3-difluorphenyl)-titan
Bis(cyclopentadienyl)-bis(2,5-difluorphenyl)-titan
Bis(cyclopentadienyl)-bis(2,3,4,5-tetrafluorphenyl)-titan
Bis(methylcyclopentadienyl)-bis(2,3,4,5-tetrafluorphenyl)-titan
Bis(methylcyclopentadienyl)-bis(2,3,4,6-tetrafluorphenyl)-titan
Bis(methylcyclopentadienyl)-bis(2,3,6-trifluorphenyl)-titan
Bis(methylcyclopentadienyl)-bis(pentafluorphenyl)-titan
Bis(cyclopentadienyl)-3,4,5,6,3',4',5',6'-octafluordiphenylsulfid-2,2'-diyl-titan
Bis(cyclopentadienyl)-bis[4-(4,4-dimethylpiperazino)-tetrafluorphenyl]-titan-diiodid
Bis(cyclopentadienyl)-bis[4-(trimethylammonium-methyl)-tetrafluorphenyl)-titan-diiodid

In den Verbindungen der Formel VII ist das Titan ebenso wie in den Verbindungen der Formel IV an zwei π-Anionen vom Cyclopentadienyltyp $R^{21}$ und $R^{22}$ gebunden. Die anderen beiden Liganden $R^{28}$ und $R^{29}$ unterscheiden sich jedoch von $R^{23}$ und $R^{24}$ dadurch, dass der aromatische Rest $R^{28}$ mindestens in einer ortho-Position eine $CF_3$-Gruppe enthält. Der Rest $R^{29}$ kann ebenfalls ein ortho-Trifluoromethyl-Aromat sein oder ist Alkinyl, Phenylalkinyl, Alkoxy, Aryloxy, unsubstituiertes oder mit Halogen substituiertes Acyloxy, Halogen, $—SI(R^{25})_3$, $—Si(R^{25})_2(R^{26})$, $—Sn(R^{25})_3$, —OH, —CN, $—N_3$, —NCO oder —NCS, analog zum Rest $R^{24}$. $R^{29}$ als Halogen ist insbesondere Fluor, Chlor oder Brom.

Beispiele für Verbindungen der Formel VII sind:

Bis(cyclopentadienyl)-2-(trifluormethyl)phenyl-titan-chlorid oder -bromid oder -fluorid oder -acetat oder -trifluoracetat

Bis(cyclopentadienyl)-bis-(2-trifluormethyl)phenyl-titan

Bis(methylcyclopentadienyl)-2-(trifluormethyl)phenyl-titan-chlorid oder -fluorid oder -acetat oder -trifluoracetat

Bis(cyclopentadienyl)-(2-trifluormethyl-6-fluorphenyl)-titan-fluorid

Bis(cyclopentadienyl)-2,5-bis(trifluormethyl)phenyl-tital-chlorid

Bis(indenyl)-2,5-bis(trifluormethyl)phenyl-titan-chlorid

Bis(methylcyclopentadienyl)-2-(trifluormethyl)phenyl-titan-rhodanid oder -isocyanat oder -cyanid oder -trichloracetat

Bis(cyclopentadienyl)-2-(trifluormethyl)phenyl-titan-rhodanid oder -azid

Bis(cyclopentadienyl)-(2-trifluormethyl-4-methoxyphenyl)-titan-chlorid

Bis(cyclopentadienyl)-bis(2-trifluormethyl-4-tolyl)-titan.

In den erfindungsgemässen Gemischen beträgt das prozentuale Gewichtsverhältnis von A:B = 70—99,9:0,1—30, bevorzugt ist ein Verhältnis von 90—99,5 Gew.-% A: 0,5—10 Gew.-% B. Die Komponente A stellt also mengenmässig den Hauptanteil dar.

Bevorzugt sind Gemische, worin die Komponente A) entweder

$A_1$) ein flüssiges Benzilketal der Formel I ist, worin

$Ar^1$ und $Ar^2$ Phenyl, Tolyl, Chlorphenyl oder Bromphenyl sind,

$R^1$ $C_4$—$C_{18}$, $C_3$—$C_5$-Alkenyl, —$CH_2COOR^4$, —$R^5$—X, $-[CH(R^3)—CH_2—O]_m-R^6$ oder Tetrahydrofurfuryl bedeutet, worin $R^3$ H oder $CH_3$ ist,

$R^4$ $C_1$—$C_{18}$-Alkyl, Allyl, oder $C_3$—$C_6$-Alkoxyalkyl ist, $R^5$ $C_2$—$C_4$-Alkylen ist, X Halogen, —$COOR^4$, —$OR^4$ oder eine tertiäre Aminogruppe mit 2—12 C-Atomen bedeutet,

m 1—25 und $R^6$ $C_1$—$C_{18}$-Alkyl oder $C_{12}$—$C_{22}$-Alkylphenyl bedeutet, und

$R^2$ Methyl ist oder eine der für $R^1$ gegebenen Bedeutungen hat, oder

$A_2$) ein flüssiges Dioxolan der Formel ist, worin

$R^{11}$ Wasserstoff, $C_1$—$C_5$-Alkyl, $C_2$—$C_8$-Alkoxyalkyl, $C_2$—$C_4$-Hydroxyalkyl oder Benzyl bedeutet,

$R^{12}$ Phenyl oder 2-Furyl ist oder eine der für $R^{11}$ gegebenen Bedeutungen hat oder $R^{11}$ und $R^{12}$ zusammen mit dem C-Atom, an das sie gebunden sind, einen Cyclopentan- oder Cyclohexanring bilden,

$R^{13}$ $C_1$—$C_4$-Alkyl oder Phenyl ist,

$R^{14}$ Wasserstoff oder $C_1$—$C_4$-Alkyl ist,

$R^{15}$ Wasserstoff, $C_1$—$C_4$-Alkyl oder Phenyl ist, und

$R^{16}$ Wasserstoff, Chlor, Methyl oder Methoxy bedeutet, oder

$A_3$) ein flüssiges Acetal oder Ketal der Formel III ist, worin $Ar^3$ Phenyl ist, $R^{17}$ Wasserstoff ist und $R^{18}$ und $R^{19}$ $C_1$—$C_4$-Alkyl sind und worin die Komponente B eine Titanocenverbindung der Formel IV ist, worin

$R^{21}$ and $R^{22}$ ein unsubstituiertes oder durch $C_1$—$C_4$-Alkyl substituiertes Cyclopentadienyl-Anion sind und

$R^{23}$ und $R^{24}$ eine Gruppe der Formel VIII bedeuten,

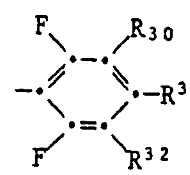

VIII

worin

$R^{30}$, $R^{31}$ und $R^{32}$ unabhängig voneinander Wasserstoff, F, Cl, Br, $C_1$—$C_{14}$-Alkoxy, eine tertiäre Aminogruppe oder Aminomethylgruppe mit 2—20 C-Atomen oder eine quartäre Ammonium- oder Ammoniummethylgruppe mit 3—24 C-Atomen bedeuten oder

$R^{23}$ und $R^{24}$ zusammen eine zweiwertige Gruppe der Formel

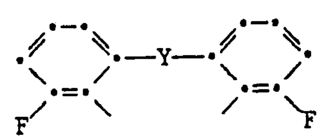

darstellen, worin Y die in Anspruch 1, angegebene Bedeutung hat,

oder worin die Komponente B eine Titanocenverbindung der Formel VII ist, worin $R^{21}$ und $R^{22}$ ein unsubstituiertes oder durch $C_1$—$C_4$-Alkyl substituiertes Cyclopentadienyl-Anion sind und $R^{28}$ eine Gruppe der Formel IX bedeutet,

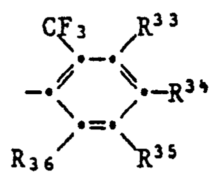

IX

worin $R^{33}$, $R^{34}$, $R^{35}$ und $R^{36}$ unabhängig voneinander Wasserstoff, F, Cl, Br oder $C_1$—$C_{14}$-Alkoxy bedeuten und $R^{29}$ eine der für $R^{28}$ gegebenen Bedeutungen hat oder F, Cl, Br, CN, $N_3$, unsubstituiertes oder mit Halogen substituiertes $C_2$—$C_4$-acyloxy, —NCO oder —NCS bedeutet.

Bevorzugt sind weiterhin Gemische, worin die Komponente A entweder eine Verbindung oder ein technisches Gemisch der Formel I ist, worin $Ar^1$ und $Ar^2$ Phenyl sind, $R^1$ $C_4$—$C_{16}$-Alkyl, —$CH_2$—COO($C_1$—$C_4$-Alkyl), —$CH_2CH_2X$ oder $-[CH_2CH_2O]_m-R^6$ bedeutet, worin X Chlor, $C_1$—$C_8$-Alkoxy oder eine tertiäre Aminogruppe mit 2—8 C-Atomen ist, m ein Wert von 2 bis 20 ist und $R^6$ $C_8$—$C_{16}$-Alkyl oder $C_{13}$—$C_{16}$-Alkylphenyl ist, $R^2$ Methyl ist oder eine der für $R^1$ angegebenen Bedeutungen hat, oder eine Verbindung der Formel II ist, worin $R^{11}$ und $R^{12}$ Methyl sind oder zusammen mit dem C-Atom, an das sie gebunden sind, einen Cyclopentan- oder Cyclohexanring bilden, $R^{13}$ Methyl oder Phenyl ist, $R^{14}$ H oder Methyl ist, $R^{15}$ H, Methyl oder Phenyl ist und $R^{16}$ H, Methyl oder Methoxy ist, oder worin die Komponente A 2,2-Dimethoxyacetophenon oder 2,2-Diethoxyacetophenon ist, insbesondere solche Gemische, die als Komponente A

eine Verbindung oder ein technisches Gemisch der Formel enthalten.

Besonders bevorzugt sind Gemische, die als Komponente A eine Verbindung der Formel I enthalten, worin $Ar^1$ und $Ar^2$ Phenyl sind und $R^1$ und $R^2$ $-\!\!\left[CH_2CH_2O\right]_m\!\!-R^6$ bedeuten, woring m ein Wert von 2 bis 12 ist und $R^6$ $C_8$-$C_{16}$-Alkyl oder $C_{13}$—$C_{16}$-Alkylphenyl ist.

Besonders bevorzugt sind weiterhin Gemische, die als Komponente B eine Verbindung der Formel IV enthalten, worin $R^{21}$ und $R^{22}$ ein Cyclopentadienyl- oder Methylcyclopentadienyl-Anion sind und $R^{23}$ und $R^{24}$ eine Gruppe der Formel VIII sind, worin entweder a) $R^{30}$ H, F, Cl oder Br ist, $R^{31}$ Fluor oder $C_1$—$C_{14}$-Alkoxy ist und $R^{32}$ H, Cl, oder Br ist oder b) $R^{30}$ und $R^{32}$ H, F, Cl oder Br sind und $R^{31}$ H, Cl, Br, $C_1$—$C_{14}$-Alkoxy, eine tertiäre Amino-oder Aminomethylgruppe oder eine quartäre Ammonium- oder Ammoniummethylgruppe ist, sowie Gemische, die als Komponente B eine Verbindung der Formel VII erhalten, worin $R^{21}$ und $R^{22}$ ein Cyclopentadienyl- oder Methylcyclopentadienyl-Anion sind, $R^{28}$ 2(Trifluormethyl)phenyl oder 6-Fluor-2-(trifluormethyl)phenyl bedeutet und $R^{29}$ die gleiche Bedeutung wie $R^{28}$ hat oder F, Cl, Br, CN, $N_3$, —O—CO—$CH_3$, —O—CO—$CF_3$, —NCO oder —NCS ist.

Die Verbindungen der Formel I sind zum Teil bekannte und zum Teil neue Verbindungen. Neue Verbindungen der Formel I sind insbesondere solche, worin $Ar^1$ und $Ar^2$ unabhängig voneinander Phenyl oder durch $C_1$—$C_4$-Alkyl oder Halogen substituiertes Phenyl sind, $R^1$ eine Gruppe der Formel $-\!\!\left[CH_2CH_2O\right]_m\!\!-(C_8$—$C_{16}$-Alkyl) oder $-\!\!\left[CH_2CH_2O\right]_m\!\!-C_6H_4$—$C_7$—$C_{10}$-Alkyl) ist, wobei m ein Wert von 2—20 ist, und $R^2$ $C_1$—$C_4$-Alkyl ist oder die für $R^1$ gegebene Bedeutung hat. Darunter sind diejenigen Verbindungen bevorzugt, but denen $R^1$ und $R^2$ gleich sind.

Diese neuen Verbindungen können hergestellt werden durch Transketalisierung von Niederalkylketalen der Formel

$$Ar^1-CO-\underset{OR}{\overset{OR}{C}}-Ar^2 \qquad R = C_1-C_4\text{-Alkyl}$$

mit oxyethylierten Alkoholen der Formel $C_8$—$C_{16}$-Alkyl$-\!\!\left[OCH_2CH_2\right]_m\!\!-OH$ oder $C_1$—$C_{15}$-Alkyl—$C_6H_4-\!\!\left[OCH_2CH_2O\right]_m\!\!-OH$. Hierzu verwendet man saure Katalysatoren wie konzentrierte Mineralsäuren, organische Sulfonsäuren oder Lewis-Säuren. Beispiele solcher Katalysatoren sind konzentrierte Schwefelsäure, konzentrierte Phosphorsäure, Chlorwasserstoff, Toluolsulfonsäure, Methansulfonsäure, Trifluoromethansulfonsäure, Borfluorid oder Aluminiumchlorid. In Gegenwart solcher Katalysatoren verläuft die Reaktion bei etwa 70—120°C in befriedigender Geschwindigkeit. Der dabei freigesetzte Alkohol ROH wird laufend aus dem Reaktionsgemisch abdestilliert. Aus der Menge des abdestillierten Alkohols kann man den Fortschritt der Reaktion kontrollieren.

Die als Ausgangsmaterial verwendeten Niederalkylketale sind bekannte Verbindungen. Bevorzugt verwendet man die Entsprechenden Benzildimethylketale ($R = CH_3$), da diese gut zugänglich oder auch wie das unsubstituierte Benzildimethylketal im Handel erhältlich sind. Die oxyethylierten Alkohole sind ebenfalls im Handel erhältlich, wobei es sich um technische Gemische aus Verbindungen mit verschieden langen Alkylresten und mit verschiedenem Oxethylierungsgrad m handelt. Der Inex m ist daher ein Mittelwert. Bei Verwendung solcher Gemische oxethylierter Alkohole erhält man dementsprechende Ketal-Gemische. Diese sind flüssige Verbindungen, die für sich allein als Initiatoren für die Photopolymerisation ethylenisch ungesättigter Verbindungen geeignet sind, sich insbesondere aber als Komponente A für Gemische mit Titanocenen der Formel IV oder VII gut eignen, da sie eine hohe Lösekraft für solche Verbindungen besitzen.

Eine weitere Klasse von neuen Verbindungen der Formel I sind solche, worin $Ar^1$ und $Ar^2$ unabhängig voneinander Phenyl oder durch $C_1$—$C_4$-Alkyl oder Halogen substituiertes Phenyl sind und $R^1$ und $R^2$ dieselbe Bedeutung haben und je einen $C_9$—$C_{16}$-Alkylrest darstellen. Auch diese Verbindungen können durch Transketalisierung der entsprechenden Niederalkylketale hergestellt werden, unter Verwendung von $C_9$—$C_{16}$-Alkoholen. Bevorzugt sind darunter die Verbindungen, worin $R^1$ und $R^2$ je einen $C_{12}$—$C_{16}$-Alkylrest darstellen.

Die techischen Reaktionsgemische aus der Transketalisierung können nach ihrer Herstellung verschieden grosse Anteile an disubstituierten Ketalen, monosubstituierten Ketalen, nicht umgesetztem Benzildimethylketal und nicht umgesetztem Alkohol enthalten, je entsprechend den eingesetzten Mengen. Solche technische Gemische sind als Photoinitiatoren ebenfalls brauchbar.

Zur Herstellung der erfindungsgemässen Initiatorgemische verrührt man die Komponente B in der Komponente A bis eine klare Lösung entstanden ist. Vorzugsweise geschieht das Auflösen unter schwachem Erwärmen auf etwa 40—60°C. Das Auflösen soll in Dunkelräumen mit Rotlicht-Beleuchtung geschehen, da die gelösten Titanocene gegen kurzwelliges Sonnenlicht (bis zu 600 nm) empfindlich sind. Die so erhaltenen Lösungen sind im Dunkeln lange Zeit haltbar.

Die ethylenisch ungesättigten Verbindungen, die sich unter Verwendung der vorhin bezeichneten Gemische aus A und B photopolymerisieren lassen, sind dieselben Verbindungen, die auch unter Zusatz anderer bekannter Initiatoren üblicherweise verwendet werden. Es handelt sich dabei um einfach oder mehrfach ungesättigte Verbindungen, wobei die mehrfach ungesättigten Vebindungen von besonderer Bedeutung sind, da sie sich zu vernetzten — und damit unlöslichen — Produkten polymerisieren lassen.

Beispiele von einfach ungesättigten Verbindungen sind Acrylate oder Methacrylate von einwertigen Alkoholen, Acrylamide und ähnliche Acrylsäurederivate, wie z.B. Methyl-, Ethyl-, Butyl, Isooctyl- oder Hydroxyethylacrylat, Methyl- oder Ethylmethacrylat, Acrylnitril, Acrylamid, N-Butyl(methacrylamid); sowie Vinyl- und Allylverbindungen wie z.B. Vinylacetat, Vinylstearat, N-Vinylpyrrolidon, Vinylidenchlorid, Vinylbenzol oder Allylacetat.

Beispiele mehrfach ungesättigter Verbindungen sind Acrylate, Methacrylate oder Itaconate von Polyolen wie z.B. Ethylenglykoldiacrylat, Diethylenglykol-dimethacrylat, Triethylenglykol-diacrylat, Butandiol-1,4-diacrylat, Propandiol-1,2-diacrylat, Butandiol-1,3-dimethacrylat, Neopentylglykol-diacrylat, Trimethylolpropan-di(meth)acrylat, Trimethylolethan-di(meth)acrylat, Glycerin-di- und -triacrylat, Pentaerythrit-di-, -tri- und -tetraacrylat oder -methacrylat, Diphentaerythrit-tetra, -penta- und -hexaacrylate oder -methacrylat oder -itaconat, Sorbit-tetraacrylat, Sorbit-hexamethacrylat, Diacrylate oder Dimethacrylate von 1,4-Cyclohexandiol, 1,4-Dimethylolcyclohexan, Bisphenol A, 2,2-Bis(4-hydroxyphenyl)propan von Polyethylenglykolen oder von Oligoestern oder Oligourethanen mit endständigen Hydroxylgruppen. Als mehrfach ungesättigte Monomere können auch Acrylamide verwendet werden wie z.B. Methylen-bisacrylamid, Hexamethylen-1,6-bisacrylamid, Diethylentriamin-tris-methacrylamid, Bis(methacrylamidopropoxy)ethan oder 2-Acrylamido-ethylacrylat. Beispiele für mehrfach ungesättigte Vinyl- und Allylverbindungen sind Divinylbenzol, Ethylenglykoldivinylether, Diallylphthalat, Allylmethacrylat, Diallylmaleat, Triallylisocyanurat oder Triallylphosphat.

Auch polymere oder oligomere mehrfach ungesättigte Verbindungen lassen sich unter Vernetzung photopolymerisieren wie z.B. ungesättigte Polyester und Copolyester der Maleinsäure und Fumarsäure, (Meth)acrylate von Polyvinylalkohol oder Homo- oder Copolymerisate von Butadien oder Isopren. Weitere verwendbare mehrfach ungesättigte Komponenten sind die Umsetzungsprodukte von Polyepoxiden mit Acryl-oder Methacrylsäuren. Als Polyepoxide werden dabei vorwiegend die im Handel erhältlichen Epoxidharz-Vorprodukte verwendent, die in verschiedenen Molekulargewichten erhältlich sind.

Meist werden zur Photopolymerisation Gemische solcher ungesättigter Verbindungen verwendet, um die Eigenschaften der Polymerisate für den gewünschten Verwendungszweck variieren zu können. Beispiele hierfür sind Gemische von Diacrylaten mit Polyester-acrylaten oder mit Polyurethan-acrylaten, Gemische von Mono-, Di- und Triacrylaten, Gemische von ungesättigten Polyestern der Maleinsäure mit Styrol oder andere Gemische von polymer-oligomeren ungesättigten Verbindungen mit Di-, Tri oder Tetraacrylaten. Die Gemische können aus zwei, drei oder auch mehreren ungesättigten Komponenten bestehen.

Photohärtbare Zusammensetzungen, wie sie für die verschiedenen Zwecke verwendet werden, enthalten meist ausser den photopolymerisierbaren Verbindungen und den Photoinitiatoren eine Reihe sonstiger Zusätze. So ist es vielfach üblich, thermische Inhibitoren zususetzen, die vor allem während der Herstellung der Systeme durch Mischen der Komponenten vor einer vorzeitigen Polymerisation schützen sollen. Hierzu werden beispielsweise Hydrochinon, Hydrochinonderivate, p-Methoxyphenol, β-Naphthole oder sterisch gehinderte Phenole wie z.B. 2,6-Di(tert-butyl)-p-Kresol verwendet. Weiter können geringe Mengen von UV-Absorbern zugesetzt werden wie z.B. solche vom Benztriazol-, Benzophenon- oder Oxalanilid-Typ. Ebenso lassen sich Lichtschutzmittel vom Typus sterisch gehinderter Amine (HALS) zusetzen.

Zur Erhöhung der Dunkellagerstabilität können Kupferverbindungen wie Kupfernaphthenat, -stearat, oder-octoat, Phosphorverbindungen wie Triphenylphosphin, Tributylphosphin, Triäthylphosphit, Triphenylphosphit oder Tribenzylphosphit, quaternäre Ammoniumverbindungen wie Tetramethylammoniumchlorid oder Trimethyl-benzylammoniumchlorid oder Hydroxylaminderivate, wie z.B. N-Diäthylhydroxylamin, zugesetzt werden.

Um die inhibierende Wirkung des Luftsauerstoffs auszuschliessen setzt man photohärtbaren Gemischen häufig Paraffin oder ähnliche wachsartige Stoffe zu. Diese schwimmen bei Beginn der Polymerisation wegen mangelnder Löslichkeit im Polymeren aus und bilden eine transparente Oberflächenschicht, die den Zutritt von Luft verhindert.

Die photohärtbaren Zusammensetzungen können auch polymere Bindemittel enthalten, die keine ungesättigten Verbindungen sind. Beispiele hierfür sind Polyacrylate, Celluloseester und -ether, Polyvinylester, Vinylchlorid-polymerisate, Polyamide, Polyester, Polyether oder Styrol-Maleinsäureanhydrid-Copolymere. Weitere übliche Zusatzstoffe sind Pigmente, Farbstoffe, Füllstoffe, Haftvermittler, Netzmittel oder Verlaufsmittel. Für bestimmte Applikationen können auch Lösungsmittel zugesetzt werden. Vorzugsweise werden jedoch keine Lösungsmittel verwendet.

Weitere übliche Zusätze sind Photosensibilisatoren, welche in bestimmten Wellenlängen absorbieren und die absorbierte Energie an die Initiatoren weitergeben oder selbst als zusätzlicher Initiator fungieren. Beispiele hierfür sind vor allem Thioxanthon-, Anthrachinon- und Cumarinderivate.

Weitere übliche Zusätze sind Beschleuniger vom Amin-Typ, die vor allem in pigmentierten Zubereitungen von Bedeutung sind, da sie als Kettenüberträger wirken. Beispiele hierfür sind N-Methyldiethanolamin, Triethylamin, p-Diethylaminobenzoesäureethylester oder Michler's Keton. Die Wirkung der Amine kann verstärkt werden durch den Zusatz von aromatischen Ketonen vom Benzophenontyp.

Die erfindungsgemässen photohärtbaren Zusammensetzungen eignen sich als Beschichtungsmittel für Substrate aller Art, a.B. Holz, Papier, Keramik, Kunststoffe wie Polyester und Celluloseacetatfilme und Metalle wie Kupfer und Aluminium, bei denen durch Photopolymerisation eine Schutzschicht oder eine

Abbildung aufgebracht werden soll.

Grosse Bedeutung hat die Photohärtung für Druckfarben, da die Trocknungszeit des Bindemittels ein massgeblicher Faktor für die Produktionsgeschwindigkeit graphischer Erzeugnisse ist und in der Grössenordnung von Bruchteilen von Sekunden liegen soll. Insbesondere für den Siebdruck sind UVhärtbare Druckfarben von Bedeutung.

Bevorzugt werden die Zusammensetzungen zur Herstellung von Druckplatten, Resistmaterialien, Bildaufzeichnungsmaterialien oder sonstigen Informationsträgern verwendet.

Gut geeignet sind die erfindungsgemässen photohärtbaren Gemische auch zur Herstellung von Druckplatten. Hierbei werden z.B. Gemische von löslichen linearen Polyamiden mit photopolymerisierbaren Monomeren, beispielsweise Acrylamiden, und einem Photoinitiator verwendet. Filme und Platten aus diesen Systemen werden Über das Negativ (oder Positiv) der Druckvorlage belichtet und die angehärteten Anteile anschliessend mit einem Lösungsmittel eluiert.

Ein weiteres Einsatzgebiet der Photohärtung ist die Metallbeschichtung, beispielsweise bei der Lackierung von Blechen für Tuben, Dosen der Flaschenverschlüssen, sowie die Photohärtung von Kunststoffbeschichtungen, beispielsweise von Fussboden- oder Wandbelägen aus PVC-Basis.

Beispiele für die Photohärtung von Papierbeschichtungen sind die farblose Lackierung von Etiketten, Schallplatten-Hüllen oder Buchumschlägen.

Wichtig ist auch die Verwendung der photohärtbaren Zusammensetzungen für Abbildungsverfahren und zur optischen Herstellung von Informationsträgern. Hierbei wird die auf dem Träger aufgebrachte Schicht durch eine Photomaske mit kurzwelligem Licht bestrahlt und die unbelichteten Stellen der Schicht durch Behandlung mit einem Lösungsmittel (= Entwickler) entfernt. Die belichteten Stellen sind vernetztpolymer und dadurch unlöslich und bleiben auf dem Träger stehen. Bei entsprechender Anfärbung entstehen sichtbare Bilder. Ist der Träger eine metallisierte Schicht, so kann das Metall nach dem Belichten und Entwicklen an den unbelichteten Stellen weggeätzt oder durch Galvanisieren verstärkt werden. Auf diese Weise lassen sich gedruckte Schaltungen und Photoresists herstellen.

Zur Belichtung eignen sich Lichtquellen mit hohem Anteil an kurzwelligem Licht. Hierfür stehen heute entsprechende technische Vorrichtungen und verschiedene Lampenarten zur Verfügung. Beispiele sind Kohlelichtbogenlampen, Xenonlichtbogenlampen, Quecksilberdampflampen, Metall-Halogenlampen, Fluoreszenzlampen, Argonglühlampen, oder photographische Flutlichtlampen. Neuerdings werden auch Laserlichtquellen verwendet. Diese lassen sich auch ohne Photomasken einsetzen; der gesteuerte Laserstrahl schreibt dann direkt auf die photohärtbare Schicht.

Die erfindungsgemässen photohärtbaren Zusammensetzungen besitzen eine gute Dunkellagerbeständigkeit.

Die folgenden Beispiele erläutern die Herstellung der neuen Verbindungen sowie die Bereitung und die Verwendung der Initiatorgemische. Darin bedeuten Teile Gewichtsteile und % Gewichts-%.

Beispiel 1

2,2-Bis[(3,6,9,12,15-pentoxapentacosyl)-oxy]-1,2-diphenyl-ethan-2-on und analoge Ketale

Ein Gemisch von 76,9 g (0,3 Mol) Benzildimethylketal, 227,1 g (0,6 Mol) Dobanol® 91—5 (technisches Alkoholgemisch mit der durchschnittlichen Zusammensetzung von $C_{10}H_{21}\text{-}(O\text{—}CH_2\text{—}CH_2)_5\text{-}OH$ der Fa. Shell Chemie) und 2,0 g (3,5 Mol%) Toluol-4-sulfonsäure-Monohydrat wird unter Wasserstrahlvakuum (20—30 mbar) auf 105—110°C erwärmt. Bei 50°C ist alles gelöst. Der Reaktionsverlauf wird dünnschichtchromatographisch verfolgt. Die Reaktion wird beendet, wenn weniger als 1% Benzildimethylketal vorhanden ist. Dies ist nach etwa 20 h der Fall. Die gelbe, leicht trübe Lösung wird nun gekühlt und mit 2,0 g einer 30%igen Lösung von Natriummethylat in Methanol neutralisiert. Dann wird unter Wasserstrahlvakuum erwärmt und während zwei Stunden bei 60°C gerührt, um das Methanol zu entfernen. Die dunkelbraune Lösung wird mit 500 ml Toluol verdünnt, mit 20 g Aktivkohle verrührt und über ein Hyflobett filtriert. Das Filtrat wird am Vakuum eingeengt. Es resultieren 257,0 g einer cognacfarbenen Flüssigkeit (Photoinitiator A—1)

Elementaranalyse: $C_{54}H_{92}O_{13}$ (949,33)
Berechnet: C 68,32% H 9,77%
Gefunden: C 67,97% H 9,88%

Analog wurden folgende flüssige Benzilketale hergestellt:

| | | | |
|---|---|---|---|
| aus Dobanol®91-6 | (Photoinitiator A-2) | | |
| $C_{56}H_{96}O_{15}$ | ber. | C 66,64 % | H 9,59 % |
| (1009,38) | gef. | C 66,69 % | H 9,74 % |

| | | | |
|---|---|---|---|
| aus Dobanol®91-8 | (Photoinitiator A-3) | | |
| $C_{64}H_{112}O_{19}$ | ber. | C 64,84 % | H 9,52 % |
| (1185,59) | gef. | C 64,88 % | H 9,59 % |
| aus Dobanol®23-3 | (Photoinitiator A-4) | | |
| $C_{50}H_{84}O_{9}$ | ber. | C 72,42 % | H 10,21 % |
| (829,22) | gef. | C 72,40 % | H 10,27 % |
| aus Dobanol®23-6,5 | (Photoinitiator A-5) | | |
| $C_{68}H_{120}O_{17}$ | ber. | C 67,52 % | H 10,00 % |
| (1209,70) | gef. | C 67,36 % | H 9,94 % |
| aus Dobanol®25-3 | (Photoinitiator A-6) | | |
| $C_{52}H_{88}O_{9}$ | ber. | C 72,85 % | H 10,35 % |
| (857,27) | gef. | C 73,04 % | H 10,35 % |
| aus Dobanol®25-7 | (Photoinitiator A-7) | | |
| $C_{68}H_{120}O_{17}$ | ber. | C 67,52 % | H 10,00 % |
| (1209,70) | gef. | C 67,71 % | H 10,05 % |
| aus Dobanol®25-9 | (Photoinitiator A-8) | | |
| $C_{76}H_{136}O_{21}$ | ber. | C 65,87 % | H 9,89 % |
| (1385,92) | gef. | C 65,99 % | H 9,90 % |
| aus Dobanol®45-7 | (Photoinitiator A-9) | | |
| $C_{70}H_{124}O_{17}$ | ber. | C 67,93 % | H 10,10 % |
| (1237,75) | gef. | C 68,08 % | H 9,90 % |
| aus Dobanol®45-11 | (Photoinitiator A-10) | | |
| $C_{86}H_{156}O_{25}$ | ber. | C 64,96 % | H 9,89 % |
| (1590,17) | gef. | C 64,88 % | H 9,87 % |
| aus Igepal®CA 520 (GAF Corporation) | (Photoinitiator A-11) | | |
| $C_{62}H_{92}O_{13}$ | ber. | C 71,23 % | H 8,87 % |
| (1045,42) | gef. | C 71,26 % | H 8,89 % |
| aus Igepal®CO 520 | (Photoinitiator A-12) | | |
| $C_{64}H_{96}O_{13}$ | ber. | C 71,61 % | H 9,01 % |
| (1073,47) | gef. | C 71,05 % | H 9,01 % |

Beispiel 2

1,2-Diphenyl-2-methoxy-2-[(3,6,9,12,15-pentoxapentacosyl))oxy]-ethan-2-on und analoge Ketale

Ein Gemisch von 76,9 g (0,3 Mol) Benzildimethylketal, 113,6 g (0,3 Mol) Dobanol® 91—5 (technisches Alkoholgemisch mit der durchschnittlichen Zusammensetzung von $C_{10}H_{21}-(O-CH_2CH_2)_5-OH$ der Fa. Shell) und 1,0 g (1,75 Mol%) Toluol-4-sulfonsäure-Monohydrat wird unter Wasserstrahlvakuum (20—30 mbar) auf 100—105°C erwärmt. Bei 58°C ist alles gelöst. Der Reaktionsverlauf wird mit DC verfolgt.

Nach 17 Stunden ist die Reaktion beendet. Die gelbe, schwach trübe Lösung wird nun gekühlt und mit 1,0 g 30%iger methanolischer Natriummethylatlösung neutralisiert, wobei die Lösung gegen Ende der Neutralisation nachdunkelt. Dann wird unter Wasserstrahlvakuum aufgeheizt und während zwei Stunden bei 60°C gerührt, um das Methanol zu entfernen. Die braune Lösung wird mit 400 ml Toluol verdünnt, mit 10 g Aktivkohle verrührt und über ein Hyflobett filtriert. Das Filtrat wird am Vakuum eingeengt. Es resultieren 169,0 g (93,4% der Theorie) einer gelben Flüssigkeit. (Photoinitiator A—13).

Elementaranalyse: $C_{35}H_{54}O_8$ ((602,82)
Berechnet: C 69,74% H 9,03%
Gefunden: C 69,59% H 9,10%

Analog wurden folgende flüssige Benzilketale hergestellt:

| | | | |
|---|---|---|---|
| aus Igepal®CA 520 | (Photoinitiator A-14) | | |
| $C_{39}H_{54}O_8$ | ber. | C 71,97 % | H 8,36 % |
| (650,86) | gef. | C 72,03 % | H 8,28 % |
| aus Igepal®CO 520 | (Photoinitiator A-15) | | |
| $C_{40}H_{54}O_8$ | ber. | C 72,26 % | H 8,49 % |
| (664,89) | gef. | C 71,85 % | H 8,34 % |

Beispiel 3

2,2-Bis-decyloxy-1,2-diphenyl-ethan-2-on und analoge Ketale

Ein Gemisch von 76,9 g (0,3 Mol) Benzildimethylketal, 95,0 g (0,6 Mol) Decanol und 2,0 g (3,5 Mol%) Toluol-4-sulfonsäure Monohydrat wird unter Wasserstrahlvakuum (20—30 mbar) auf 85°C erwärmt. Bei 60°C ist alles gelöst. Die Reaktion wird mit DC und GC verfolgt. Nach 3,5 Stunden ist weniger als 1% Benzildimethylketal vorhanden. Nun wird die gelbe Lösung gekühlt und mit 2,0 g einer 30%igen Natriummethylatlösung in Methanol neutralisiert. Dann wird unter Wasserstrahlvakuum aufgeheizt und 2 Stunden bei 60°C gerührt, um das Methanol zu entfernen. Die gelbe Lösung wird mit 500 ml Toluol verdünnt, mit 10 g Aktivkohle verrührt und über ein Hyflobett filtriert. Das Filtrat wird am Vakuum eingeengt. Es resultieren 149 g einer gelben Flüssigkeit, die gemäss einer gaschromatographischen Analyse aus ca. 84% Benzildidecylketal, ca. 9% Benzildecylmethylketal, ca. 4% nicht ungesetztem Decanol, ca. 2% Benzil und ca. 0,7% Benzilmethylketal zusammengesetzt ist. Die Struktur der Komponenten wurde durch ein $^1$H—NMR—Spektrum bestätigt. (Photoinitiator A—16)

Elementaranalyse: $C_{34}H_{52}O_3$ ((508,79)
Berechnet: C 80,26% H 10,30%
Gefunden: C 79,91% H 9,63%

Analog wurden folgende flüssige Benzilketale hergestellt:

| | | | |
|---|---|---|---|
| aus Dobanol® 91 (von Shell) | (Photoinitiator A-17) | | |
| $C_{34}H_{52}O_3$ | ber. | C 80,26 % | H 10,30 % |
| (508,79) | gef. | C 80,10 % | H 10,24 % |
| aus Dobanol® 23 | (Photoinitiator A-18) | | |
| $C_{40}H_{64}O_3$ | ber. | C 81,03 % | H 10,88 % |
| (592,95) | gef. | C 81,12 % | H 10,66 % |
| aus Dobanol® 25 | (Photoinitiator A-19) | | |
| $C_{42}H_{68}O_3$ | ber. | C 81,23 % | H 11,04 % |
| (621,01) | gef. | C 81,23 % | H 10,83 % |
| aus Dobanol® 45 | (Photoinitiator A-20) | | |
| $C_{42}H_{68}O_3$ | ber. | C 81,23 % | H 11,04 % |
| (621,01) | gef. | C 81,04 % | H 11,13 % |

aus Alfol® 1014 (von Condea Petrochemie) (Photoinitiator A-21)

| | | | |
|---|---|---|---|
| $C_{38}H_{60}O_3$ | ber. | C 80,08 % | H 10,71 % |
| (564,90) | gef. | C 80,72 % | H 11,00 % |

aus Alfol® 1218 (Photoinitiator A-22)

| | | | |
|---|---|---|---|
| $C_{40}H_{64}O_3$ | ber. | C 81,03 % | H 10,88 % |
| (592,95) | gef. | C 80,81 % | H 11,21 % |

aus Isotridecylalkohol (techn. Gemisch) (Photoinitiator A-23)

| | | | |
|---|---|---|---|
| $C_{40}H_{64}O_3$ | ber. | C 81,03 % | H 10,88 % |
| (592,95) | gef. | C 80,95 % | H 10,77 % |

aus Hexadecanol (Photoinitiator A-24)

| | | | |
|---|---|---|---|
| $C_{46}H_{76}O_3$ | ber. | C 81,60 % | H 11,31 % |
| (677,12) | gef. | C 81,54 % | H 11,44 % |

## Beispiel 4

1,2-Diphenyl-2-decyloxy-2-methoxy-ethan-2-on

Ein Gemisch von 76,9 g (0,03 Mol) Benzildimethylketal, 47,5 g (0,3 Mol) Decanol und 1,0 g (1,75 Mol%) Toluol-4-sulfonsäure-Monohydrat wird unter Wasserstrahlvacuum (20—30 mbar) auf 85°C erwärmt. Bei 60°C ist alles gelöst. Der Reaktionsverlauf wird mit DC und GC verfolgt. Nach 2,5 Stunden sind weniger als 1% Decanol vorhanden. Die gelbe Lösung wird nun bekühlt und mit 1,0 g (30%iger) Natriummethylatlösung neutralisiert. Dann wird unter Wasserstrahlvakuum erwärmt und während 2 Stunden bei 60°C gerührt, um das Methanol zu entfernen. Die gelbe Lösung wird mit 250 ml Toluol verdünnt, mit 10 g Aktivkohle verrührt und über ein Hyflobett filtriert. Das Filtrat wird am Vakuum eingeengt. Es resultieren 113,2 g (98,6% der Theorie) einer gelben Flüssigkeit, die gemäss einer gaschromatographischen Analyse aus ca. 48% Benzildecylmethylketal, ca. 33% Benzildidecylketal, ca. 15% nicht umgesetzten Benzildimethylketal, ca. 3% Benzil und ca. 0,1% Decanol zusammengesetzt ist. Die Struktur der Komponenten wurde durch ein $^1H$—NMR—Spektrum bestätigt. (Photoinitiator A—25)

Elementaranalyse: $C_{25}H_{34}O_3$ (382,55)
Berechnet: C 78,49% H 8,96%
Gefunden: C 78,42% H 8,90%

25 g dieses Gemisches werden über Kieselgel mittels Mitteldruckflüssigkeitschromatographie (Labomatic, Allschwil, Schweiz) getrennt (vergl. Th. Leutert und E. von Arx, J. Chrom, *292* (1984) 333—344). Als Laufmittel wird ein Gemisch aus Hexan und Essigsäureethylat im Verhältnis 9:1 verwendet. Nur die reinen Fraktionen werden gesammelt und eingeengt. Es werden 8,2 g Benzildidecylketal (Photoinitiator A—26) und 6,1 g Benzildecylmethylketal (Photoinitiator A—27) als farblose Flüssigkeit isoliert, die sich im Gaschromatogramm als mindestens 98,5% rein erweisen.

Elementaranalyse des Decyl-methyl-ketals: $C_{25}H_{34}O_3$ (382,55)
Berechnet: C 78,49% H 8,96%
Gefunden: C 78,78% H 8,71%

Elementaranalyse des Didecylketals $C_{34}H_{52}O_3$ (508,79)
Berechnet: C 80,26% H 10,30%
Gefunden: C 80,15% H 10,22%

Analog werden die folgenden flüssigen Benzilketale als Reaktionsgemische hergestellt:

aus Dobanol® 91 (Photoinitiator A—28)

| | | | |
|---|---|---|---|
| $C_{25}H_{34}O_3$ | ber. | C 78,49% | H 8,96% |
| (382,55) | gef. | C78,47% | H 8,91% |

aus Dobanol® 25 (Photoinitiator A—29)

| | | | |
|---|---|---|---|
| $C_{29}H_{42}O_3$ | ber. | C 79,41% | H 9,65% |
| (438,66) | gef. | C79,42% | H 3,98% |

Beispiel 5

Photohärtung eines Acrylat-Gemisches

Es wird eine photohärtbare Zusammensetzung hergestellt durch Mischen der folgenden Komponenten:

50 Teile eines Oligourethan-acrylates (Actilan® AJ 20, SNPE, France),
10 Teile Trimethylolpropan-triacrylat
10 Teile Dipentaerythrit-pentaacrylat
15 Teile Tripropylenglykol-diacrylat
15 Teile N-Vinylpyrrolidon
0,5 Teile eines Verlaufshilfsmittels auf Silicon-Basis (BYK® 300, Byk-Mallinckrodt, BRD)

Portionen dieser Zusammensetzung werden mit den in der folgenden Tabelle angegebenen Menge an Photoinitiator oder Initiatorgemischenvermischt. Bei den Initiatorgemischen handelt es sich um erfindungsgemässe Lösungen eines Titanocens (Komponente B) in einem flüssigen Initiator vom Ketal-Typ (Komponente A). Alle Operationen werden unter Rotlicht oder Gelblicht ausgeführt.

Die mit Initiator versetzten Proben werden in einer Stärke von 100 µm auf Aluminiumbleche (10 × 15 cm) aufgetragen. Auf die flüssige Schicht wird eine 76 µm dicke Polyesterfolie gelegt und auf diese ein standardisiertes Testnegativ mit 21 Stufen verschiedener optischer Dichte (Stauffer-Kiel) gelegt. Darüber wird eine zweite Polyesterfolie gelegt und das so erhaltene Laminat auf einer Metallplatte fixiert. Die Probe wird dann mit einer 5 KW-Metall-halogenid-Lampe im Abstand von 30 cm belichtet und zwar in einer ersten Tetreihe 5 Sekunden und in einer zweiten Testreihe 10 Sekunden. Nach der Belichtung werden die Folien und die Maske entfernt, die belichtete Schicht in einem Ethanolbad 15 Sekunden entwickelt und anschliessend bei 60°C 5 Min getrocknet. Die Empfindlichkeit des verwendeten Initiatorsystems wird durch die Angabe der letzten klebefrei abgebildeten Keilstufe charakterisiert. Je höher die Zahl der Stufen ist, desto empfindlicher ist das System. Eine Erhöhung um zwei Stufen bedeutet dabei etwa eine Verdopplung der Härtungsgeschwindigkeit.

Als Initiatoren werden — einzeln und im Gemisch — eine Reihe der vorstehend angegebenen Photoinitiatoren A—1 bis A—29 verwendet, sowie die folgenden Initiatoren:

A—30 4-Benzoyl-2,2,4-trimethyl-1,3-dioxolan
A—31 4-Benzoyl-2-methyl-4-phenyl-1,3-dioxolan
A—32 α,α-Diethoxyacetophenon
B—1 Bis(methylcyclopentadienyl)-bis-((2,3,6-trifluorphenyl)-titan
B—2 Bis(cyclopentadienyl)-bis(4-dibutylamino-tetrafluorphenyl)-titan
B—3 Bis(methylcyclopentadienyl)-bis(4-dibutylamino-tetrafluorphenyl)-titan
B—4 Bis(methylcyclopentadienyl)-2-(trifluormethyl)phenyl-titanisocyanat
B—5 Bis(methylcyclopentadienyl)-2-(trifluormethyl)phenyl-titanazid
B—6 Bis(methylcyclopentadienyl)-2-(trifluormethyl)phenyl-titantrifluoracetat
B—7 Bis(methylcyclopentadienyl)-bis(4-decyloxy-tetrafluorphenyl)-titan

Tabelle 1

| Menge Initiator *) Komponente A | Komponente B | Zahl der abgebildeten Stufen nach 5 s | nach 10 s | Belichtung |
|---|---|---|---|---|
| 2 % A-1 | - | 5 | 7 | |
| - | 0,05 % B-1 | 6 | 8 | |
| 1,95 % A-1 | 0,05 % B-1 | 7 | 9 | |
| - | 0,1 % B-1 | 8 | 10 | |
| 1,9 % A-1 | 0,1 % B-1 | 10 | 11 | |
| - | 0,05 % B-2 | 6 | 8 | |
| 1,95 % A-1 | 0,05 % B-2 | 8 | 10 | |
| - | 0,1 % B-2 | 8 | 10 | |
| 1,9 % A-1 | 0,1 % B-2 | 10 | 11 | |
| - | 0,05 % B-3 | 6 | 8 | |
| 1,95 % A-1 | 0,05 % B-3 | 8 | 10 | |
| - | 0,1 % B-3 | 8 | 10 | |
| 1,9 % A-1 | 0,1 % B-3 | 10 | 11 | |
| - | 0,2 % B-4 | 5 | | |
| 1,8 % A-1 | 0,2 % B-4 | 7 | | |
| - | 0,2 % B-5 | 6 | | |
| 1,8 % A-1 | 0,2 % B-5 | 7 | | |
| - | 0,2 % B-6 | 7 | | |
| 1,8 % A-1 | 0,2 % B-6 | 8 | | |
| 2 % A-1 | - | 4 | 7 | 8 |
| - | 0,05 % B-6 | 4 | 6 | 8 |
| 1,95 % A-1 | 0,05 % B-6 | 4 | 6 | 10 |
| 2 % A-4 | - | 5 | 7 | 9 |
| 1,95 % A-4 | 0,05 % B-6 | 6 | 8 | 10 |
| 2 % A-13 | - | 6 | 8 | 10 |
| 1,95 % A-13 | 0,05 % B-6 | 7 | 9 | 11 |
| 2 % A-19 | - | 5 | 7 | 9 |
| 1,95 % A-19 | 0,05 % B-6 | 7 | 9 | 11 |
| 2 % A-25 | - | 7 | 8 | 11 |
| 1,95 % A-25 | 0,05 % B-6 | 7 | 9 | 11 |
| 2 % A-17 | - | 6 | 8 | 10 |
| 1,95 % A-17 | 0,05 % B-6 | 7 | 9 | 12 |

*) bezogen auf die photohärtbare Zusammensetzung

Fortsetzung Tabelle 1

| Menge Initiator *) Komponente A | Komponente B | Zahl der abgebildeten Stufen nach 5s | nach 10s | nach 15s Belichtung |
|---|---|---|---|---|
| 2 % A-11 | - | 5 | 7 | 8 |
| 1,95 % A-11 | 0,05 % B-6 | 6 | 8 | 10 |
| 2 % A-14 | - | 5 | 7 | 10 |
| 1,95 % A-14 | 0,05 % B-6 | 7 | 9 | 10 |
| 2 % A-30 | - | 4 | 6 | 7 |
| 1,95 % A-30 | 0,05 % B-6 | 6 | 8 | 10 |
| 2 % A-31 | - | 4 | 6 | 8 |
| 1,95 % A-31 | 0,05 % B-6 | 6 | 9 | 10 |
| 2 % A-32 | - | 3 | 5 | 7 |
| 1,95 % A-32 | 0,05 % B-6 | 5 | 8 | 9 |
| 2 % A-1 | - | 4 | 7 | 8 |
| - | 0,05 % B-7 | 5 | 8 | 10 |
| 1,95 % A-1 | 0,05 % B-7 | 5 | 9 | 11 |
| 2 % A-4 | - | 5 | 7 | 9 |
| 1,95 % A-4 | 0,05 % B-7 | 7 | 9 | 11 |
| 2 % A-13 | - | 6 | 8 | 10 |
| 1,95 % A-13 | 0,05 % B-7 | 7 | 10 | 12 |
| 2 % A-19 | - | 5 | 7 | 9 |
| 1,95 % A-19 | 0,05 % B-7 | 7 | 9 | 11 |
| 2 % A-25 | - | 7 | 8 | 11 |
| 1,95 % A-25 | 0,05 % B-7 | 8 | 10 | 12 |
| 2 % A-17 | - | 6 | 8 | 10 |
| 1,95 % A-17 | 0,05 % B-7 | 8 | 10 | 12 |
| 2 % A-11 | - | 5 | 7 | 8 |
| 1,95 % A-11 | 0,05 % B-7 | 8 | 10 | 12 |
| 2 % A-14 | - | 5 | 7 | 10 |
| 1,95 % A-14 | 0,05 % B-7 | 7 | 9 | 11 |
| 2 % A-30 | - | 4 | 6 | 7 |
| 1,95 % A-30 | 0,05 % B-7 | 6 | 8 | 10 |
| 2 % A-31 | - | 4 | 6 | 8 |
| 1,95 % A-31 | 0,05 % B-7 | 6 | 8 | 10 |
| 2 % A-32 | - | 3 | 5 | 7 |
| 1,95 % A-32 | 0,05 % B-7 | 6 | 8 | 10 |

*) bezogen auf die photohärtbare Zusammensetzung

Beispiel 6

Härtung eines ungesättigten Polyesterharzes

Jeweils 0,4 g flüssiges Benzilketal und 0,1 g eines Verlaufshilfsmittels (Byk® 300, Byk-Mallinckrodt) werden in 20 g eines ungesättigten Polyesterharzes (Roskydal® 502, Bayer AG) gelöst. Diese Mischungen werden in einer Schichtdicke von 100 µm auf weissem Karton aufgetragen. Die Proben werden in einem PPG-Bestrahlungsgerät mit 2 Lampen à 80 W/cm bei einer Bandgeschwindigkeit von 10 m/min bestrahlt. Hierbei wird bestimmt, wieviel Durchläufe bis zur Wischfestigkeit der Probe notwendig sind.

Zur Beurteilung der Dunkellagerbeständigkeit werden die Mischungen unter Lichtausschluss 16 Tage bei 60°C gelagert.

Folgende Photoinitiatoren werden verwendet: A—1, A—4, A—11, A—12, A—13, A—14, A—15, A—16, A—17, A—18, A—19, A—20, A—25, A—26, A—27.

In allen Fällen genügten zwei Durchgänge durch das Bestrahlungsgerät zur Erzielung eines wischfesten Filmes.

Alle Proben waren nach 16 Tagen Dunkellagerung unverändert.

**Patentansprüche**

1. Flüssiges Photoinitiatorgemisch bestehend aus

A) 70—99,9 Gew.-% mindestens eines flüssigen Acetal- oder Ketal- Photoinitiators ausgewählt aus

$A_1$) einer Verbindung der Formel I,

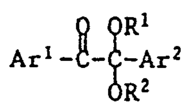

I

worin

$Ar^1$ und $Ar^2$ unabhängig voneinander Phenyl oder durch $C_1$—$C_4$-Alkyl oder Halogen substituiertes Phenyl sind,

$R^1$ $C_4$—$C_{20}$-Alkyl, $C_3$—$C_{18}$-Alkenyl, $C_7$—$C_{10}$-Phenylalkyl, eine Gruppe —CH($R^3$)—COOR$^4$, —$R^5$—X, $-[CH(R^3)—CH(R^{10})—O]_m-R^6$ oder Tetrahydrofurfuryl darstellt, worin

$R^6$ und $R^{10}$ unabhängig voneinander Wasserstoff oder Methyl sind,

$R^4$ $C_1$—$C_{20}$-Alkyl, $C_3$—$C_5$-Alkenyl oder $C_3$—$C_8$-Alkoxyalkyl ist,

$R^5$ $C_2$—$C_{10}$-Alkylen bedeutet,

X Halogen, —COOR$^4$, —OR$^4$ oder —NR$^7$R$^8$ bedeutet, wobei $R^7$ $C_1$—$C_{12}$-Alkyl, Allyl, Benzyl, Cyclohexyl, $C_2$—$C_4$-Hydroxyalkyl oder $C_3$—$C_8$-Alkoxyalkyl bedeutet, $R^8$ Wasserstoff ist oder eine der für $R^7$ gegebenen Bedeutungen hat oder $R^7$ und $R^8$ zusammen, $C_3$—$C_7$-Alkylen bedeuten, das durch O, S oder NR$^9$ unterbrochen sein kann und $R^9$ $C_1$—$C_4$-Alkyl, $C_2$—$C_4$-Hydroxylalkyl oder 2-Cyanoethyl bedeutet,

m ein Wert von 1 bis 30 ist und

$R_6$ $C_1$—$C_{20}$-Alkyl, $C_3$—$C_5$-Alkenyl, $C_3$—$C_8$-Alkoxyalkyl, $C_7$-$C_{22}$-Alkylphenyl oder $C_2$—$C_{20}$-Alkanoyl bedeutet, und

$R^2$ $C_1$—$C_3$-Alkyl ist oder eine der für $R^1$ angegebenen Bedeutungen hat oder

$A_2$) einer Verbindung der Formel II,

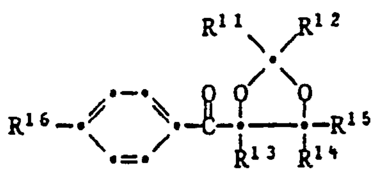

II

worin

$R^{11}$ Wasserstoff, unsubstituiertes oder durch Hydroxy oder $C_1$—$C_4$-Alkoxy substituiertes $C_1$—$C_{10}$-Alkyl oder $C_7$—$C_{10}$-Phenylalkyl bedeutet,

$R^{12}$ Phenyl, 2-Furyl oder Trichlormethyl ist oder eine der für $R^{11}$ gegebenen Bedeutungen hat, oder $R^{11}$ und $R^{12}$ zusammen mit dem C-Atom, an das sie gebunden sind, einen Cyclopentan- oder Cyclohexanring bilden,

$R^{13}$ $C_1$—$_4$-Alkyl, Phenyl oder durch eine oder mehrere Reste Cl, $C_1$—$C_4$-Alkyl oder $C_1$—$C_4$-Alkoxy substituiertes Phenyl bedeutet,

$R^{14}$ Wasserstoff oder $C_1$—$C_4$-Alkyl bedeutet,

$R^{15}$ Wasserstoff, $C_1$—$C_4$-Alkyl, Phenyl oder Trichlormethyl bedeutet,

$R^{16}$ Wasserstoff, Chlor, $C_1$—$C_4$-Alkyl oder, $C_1$—$C_4$-Alkoxy bedeutet, oder

$A_3$) einer Verbindung der Formel III,

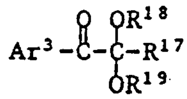

III

worin

$Ar^3$ Phenyl oder durch $C_1$—$C_4$-Alkyl oder Halogen substituiertes Phenyl ist,
$R^{17}$ Wasserstoff, $C_1$—$C_8$-Alkyl oder $C_5$—$C_8$-Cycloalkyl ist,
$R^{18}$ $C_1$—$C_8$-Alkyl oder $C_3$—$C_8$-Alkoxyalkyl ist und
$R^{19}$ eine für $R^{18}$ gegebenen Bedeutungen hat, und

B) 0,1—30 Gew.-% eines Titanocen-Photoinitiators, ausgewählt aus
$B_1$) einer Verbindung der Formel IV

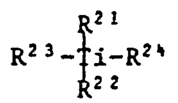

IV

worin

$R^{21}$ und $R^{22}$ unabhängig voneinander ein unsubstituiertes oder durch $C_1$—$C_4$-Alkyl, Chlor, Phenyl oder Cyclohexyl substituiertes Cyclopentadienyl- oder Indenyl-Anion bedeuten oder $R^{21}$ und $R^{22}$ zusammen ein zweiwertiges Bis-cyclopentadienyl-Anion der Formel V bedeuten,

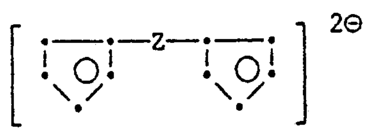

V

worin

Z Methylen, Di- oder Trimethylen, $C_2$—$C_{12}$-Alkyliden, $C_5$—$C_7$-Cycloalkyliden, —Si($R^{25}$)($R^{26}$)- oder —Sn($R^{25}$)$_2$- bedeutet und

$R^{25}$ und $R^{26}$ $C_1$—$C_{12}$-Alkyl, Phenyl oder Benzyl bedeuten,

$R^{23}$ den einwertigen Rest eines 6-gliedrigen carbocyclischen oder 5-oder 6-gliedrigen heterocyclischen aromatischen Ringes bedeutet, der in mindestens einer ortho-Position zur Bindung an das Ti-Atom durch Fluor substituiert ist und ausserdem durch eine oder mehrere der Gruppen Halogen, $C_1$—$C_{12}$-Alkyl, $C_1$—$C_{14}$-Alkoxy, $C_2$—$C_{10}$-Alkoxycarbonyl, Aminocarbonyl mit bis zu 12 C-Atomen oder durch eine primäre, sekundäre oder tertiäre Amino- oder Aminoalkylgruppe mit bis zu 20 C-Atomen oder eine quartäre Ammonium- oder Ammoniumalkylgruppe mit bis zu 30 C-Atomen substituiert sein kann,

$R^{24}$ eine der für $R^{23}$ angegebenen Bedeutungen hat oder $C_2$—$C_{12}$-Alkinyl, unsubstituiertes oder im Phenylrest durch Halogen, $C_1$—$C_4$-Alkyl, $C_1$—$C_{14}$-Alkoxy, Di-($C_2$—$C_4$-alkyl)-amino oder eine quartäre Ammoniumgruppe substituiertes Phenylalkinyl mit 2—5 C-Atomen im Alkinrest oder eine Gruppe —$N_3$, —CN, —S($R^{25}$)$_3$, —Si($R^{25}$)$_2$($R^{26}$) oder —Sn($R^{25}$)$_3$ bedeutet, oder

$R^{23}$ und $R^{24}$ zusammen einen Rest der Formel VI bedeuten,

$$—Q—Y—Q— \qquad \text{VI}$$

worin

Q ein carbocyclischer oder 5- oder 6-gliedriger heterocyclischer aromatischer Ring ist, der in 2-Stellung zur Y-Gruppe an das Titan-Atom bebunden ist und in 3-Stellung durch Fluor substituiert ist und als weitere Substituenten $C_1$—$C_4$-Alkyl, Halogen. $C_1$—$C_4$-Alkoxy, Di($C_1$—$C_4$-alkyl)amino oder eine quartäre $C_3$—$C_{20}$-Ammoniumgruppe enthalten kann,

Y Methylen, $C_2$—$C_{12}$-Alkyliden, $C_5$—$C_7$-Cycloalkyliden, eine direkte Bindung oder eine Gruppe —$NR^{27}$—, —O—, —S—, —SO—, —$SO_2$—, —CO—, —Si($R^{25}$)($R^{26}$)- oder —Sn($R^{25}$)$_2$- bedeutet und $R^{27}$ Wasserstoff, $C_1$—$C_{12}$-Alkyl, Cyclohexyl, Phenyl, Tolyl oder Benzyl bedeutet, oder

$B_2$) einer Verbindung der Formel VII,

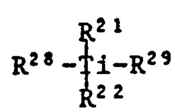

VII

worin

$R^{21}$ und $R^{22}$ die oben genannte Bedeutung haben,

$R^{28}$ den einwertigen Rest eines 6-gliedrigen carbocyclischen oder 5-oder 6-gliedrigen heterocyclischen aromatischen Ringes bedeutet, der in mindestens einer ortho-Position zur Bindung an das Ti-Atom durch

$—CF_3$, substituiert ist und ausserdem durch eine oder mehrere der Gruppen Halogen, $C_1—C_{12}$-Alkyl, $C_1—C_{14}$-Alkoxy, $C_2—C_{10}$-Alkoxycarbonyl oder Aminocarbonyl oder durch eine primäre, sekundäre oder tertiäre Amino- oder Aminoalkylgruppe mit bis zu 20 C-Atomen oder eine quartäre Ammonium- oder Ammoniumalkylgruppe mit bis zu 30 C-Atomen substituiert sein kann, und

$R^{29}$ eine der für $R^{28}$ gegebenen Bedeutungen hat oder $C_2—C_{12}$-Alkinyl, unsubstituiertes oder im Phenylrest durch Halogen oder $C_1—C_4$-Alkyl substituiertes Phenylalkinyl mit 2—5 C-Atomen im Alkinrest oder Halogen oder eine Gruppe $—Si(R^{25})_3$, $—Si(R^{25})_2(R^{26})$, $—Sn(R^{25})_3$, —OH, $C_1—C_{10}$-Alkoxy, $C_6—C_{10}$-Aryloxy, unsubstituiertes oder mit Halogen substituiertes $C_1—C_{16}$-Acyloxy, $—N_3$, —CN, —NCO oder —NCS bedeutet.

2. Flüssiges Initiatorgemisch gemäss Anspruch 1 bestehend aus

A) 99—95 Gew.% mindestens einer flüssigen Verbindung der Formel I, II oder III und

B) 0,5—10 Gew.% einer Titanocen-Verbindung der Formel IV oder VII.

3. Flüssiges Initiatorgemisch gemäss Anspruch 1, dadurch gekennzeichnet, dass die Komponente A) entweder

$A_1$) ein flüssiges Benzilketal der Formel I ist, worin

$Ar^1$ und $Ar^2$ Phenyl, Tolyl, Chlorphenyl oder Bromphenyl sind,

$R^1$ $C_4—C_{18}$-Alkyl, $C_3—C$-Alkenyl, $—CH_2COOR^4$, $—R^5—X$, $-[CH(R^3)—CH_2—O]_m-R^6$ oder Tetrahydrofurfuryl bedeutet, worin $R^3$ H oder $CH_3$ ist,

$R^4$ $C_1—C_{18}$-Alkyl, Allyl, oder $C_3—C_6$-Alkoxyalkyl ist, $R^5$ $C_2—C_4$-Alkylen ist, X Halogen, $—COOR^4$, $—OR^4$ oder eine tertiäre Aminogruppe mit 2—12 C-Atomen bedeutet,

m 1—25 und $R^6$ $C_1—C_{18}$-Alkyl oder $C_{12}—C_{22}$-Alkylphenyl bedeutet, und

$R^2$ Methyl ist oder eine der für $R^1$ gegebenen Bedeutungen hat, oder

$A_2$) ein flüssiges Dioxolan der Formel ist, worin

$R^{11}$ Wasserstoff, $C_1—C_5$-Alkyl, $C_2—C_8$-Alkoxyalkyl, $C_2—C_4$-Hydroxyalkyl oder Benzyl bedeutet,

$R^{12}$ Phenyl oder 2-Furyl ist oder eine der für $R^{11}$ gegebenen Bedeutungen hat oder $R^{11}$ und $R^{12}$ zusammen mit dem C-Atom, an das sie gebunden sind, einen Cyclopentan- oder Cyclohexanring bilden,

$R^{13}$ $C_1—C_4$-Alkyl oder Phenyl ist,

$R^{14}$ Wasserstoff oder $C_1—C_4$-Alkyl ist,

$R^{15}$ Wasserstoff, $C_1—C_4$-Alkyl oder Phenyl ist, und

$R^{16}$ Wasserstoff, Chlor, Methyl oder Methoxy bedeutet, oder

$A_3$) ein flüssiges Acetal oder Ketal der Formel III ist, worin $Ar^3$ Phenyl ist, $R^{17}$ Wasserstoff ist und $R^{18}$ und $R^{19}$ $C_1—C_4$-Alkyl sind,

und dass die Komponente B) eine Titanocenverbindung der Formel IV ist, worin

$R^{21}$ and $R^{22}$ ein unsubstituiertes oder durch $C_1—C_4$-Alkyl substituiertes Cyclopentadienyl-Anion sind und

$R^{23}$ und $R^{24}$ eine Gruppe der Formel VIII bedeuten,

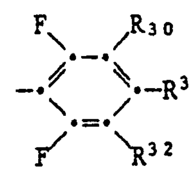

VIII

worin $R^{30}$, $R^{31}$ und $R^{32}$ unabhängig voneinander Wasserstoff, F, Cl, Br, $C_1—C_{14}$-Alkoxy, eine tertiäre Aminogruppe oder Aminomethylgruppe mit 2—20 C-Atomen oder eine quartäre Ammonium- oder Ammoniummethylgruppe mit 3—24 C-Atomen bedeuten oder

$R^{23}$ und $R^{24}$ zusammen eine zweiwertige Gruppe der Formel

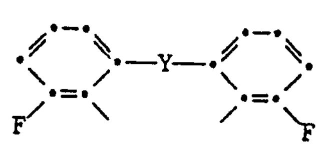

darstellen, worin Y die in Anspruch 1, angegebene Bedeutung hat,

oder dass die Komponente B eine Titanocenverbindung der Formel VII ist, worin $R^{21}$ und $R^{22}$ ein unsubstituiertes oder durch $C_1—C_4$-Alkyl substituiertes Cyclopentadienyl-Anion sind und $R^{28}$ eine Gruppe der Formel IX bedeutet,

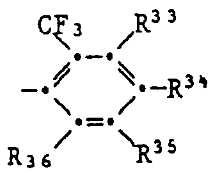

IX

worin $R^{33}$, $R^{34}$, $R^{35}$ und $R^{36}$ unabhängig voneinander Wasserstoff, F, Cl, Br oder $C_1$—$C_{14}$-Alkoxy bedeuten und $R^{29}$ eine der für $R^{28}$ gegebenen Bedeutungen hat oder F, Cl, Br, CN, $N_3$, unsubstituiertes oder mit Halogen substituiertes $C_2$—$C_4$-Acyloxy, —NCO oder —NCS bedeutet.

4. Flüssiges Initiatorgemisch gemäss Anspruch 1, dadurch gekennzeichnet, dass die Komponente A entweder eine Verbindung oder ein technisches Gemisch von Verbindungen der Formel I ist, worin $Ar^1$ und $Ar^2$ Phenyl sind, $R^1$ $C_4$—$C_{16}$-Alkyl, —$CH_2$—COO($C_1$—$C_4$-Alkyl), —$CH_2CH_2X$ oder $-\!\!\left[CH_2CH_2O\right]_m\!-R^6$ bedeutet, worin X Chlor, $C_1$—$C_8$-Alkoxy oder eine tertiäre Aminogruppe mit 2—8 C-Atomen ist, m ein Wert von 2 bis 20 ist und $R^6$ $C_8$—$C_{16}$-Alkyl oder $C_{13}$—$C_{16}$-Alkylphenyl ist, $R^2$ Methyl ist oder eine der für $R^1$ angegebenen Bedeutungen hat, oder eine Verbindung der Formel ist, worin $R^{11}$ und $R^{12}$ Methyl sind oder zusammen mit dem C-Atom, an das sie gebunden sind, einen Cyclopentan- oder Cyclohexanring bilden $R^{13}$ Methyl oder Phenyl ist, $R^{14}$ H oder Methyl ist, $R^{15}$ H, Methyl oder Phenyl ist und $R^{16}$ H, Methyl oder Methoxy ist, oder dass die Komponente A 2,2-Dimethoxyacetophenon oder 2,2-Diethoxyacetophenon ist.

5. Flüssiges Initiatorgemisch gemäss Anspruch 4, dadurch gekennzeichnet, dass die Komponente A eine Verbindung oder ein technisches Gemisch von Verbindungen Formel I ist.

6. Flüssiges Initiatorgemisch gemäss Anspruch 5, dadurch gekennzeichnet, dass die Komponente A eine Verbindung oder ein technisches Gemisch der Formel I ist, worin $R^1$ und $R^2$ $-\!\!\left[CH_2CH_2O\right]_m\!-R^6$ bedeutet, worin m ein Wert von 2—12 ist und $R^6$ $C_8$—$C_{16}$-Alkyl oder $C_{13}$—$C_{16}$-Alkylphenyl ist.

7. Flüssiges Initiatorgemisch gemäss Anspruch 3, dadurch gekennzeichnet, dass die Komponente B entweder eine Verbindung der Formel IV ist, worin $R^{21}$ und $R^{22}$ ein Cyclopentadienyl- oder Methylcyclopentadienyl-Anion sind und $R^{23}$ und $R^{24}$ eine Gruppe der Formel VIII sind, worin entweder a) $R^{30}$ H, F, Cl oder Br ist, $R^{31}$ Fluor oder $C_1$—$C_{14}$-Alkoxy ist und $R^{32}$ H, Cl oder Br ist oder b) $R^{30}$ und $R^{32}$ H, F, Cl oder Br sind und $R^{31}$ H, Cl, Br, $C_1$—$C_{14}$-Alkoxy, eine tertiäre Amino- oder Aminomethylgruppe oder eine quartäre Ammonium- oder Ammonium-methylgruppe ist, oder B eine Verbindung der Formel VII ist, worin $R^{21}$ und $R^{22}$ ein Cyclopentadienyl- oder Methylcyclopentadienyl-Anion sind, $R^{28}$ 2-(Trifluormethyl)phenyl oder 6-Fluor-2-(trifluormethyl)phenyl bedeutet und $R^{29}$ die gleiche Bedutung wie $R^{28}$ hat oder F, Cl, Br, CN, $N_3$, —O—CO—$CH_3$, —O—CO—$CF_3$, —NCO oder —NCS ist.

8. Verbindung der Formel I,

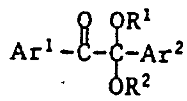

I

worin

$Ar^1$ und $Ar^2$ unabhängig voneinander Phenyl oder durch $C_1$—$C_4$-Alkyl oder Halogen substituiertes Phenyl sind, und a)

$R^1$ eine Gruppe der Formel $-\!\!\left[CH_2CH_2O\right]_m\!-(C_8$—$C_{16}$-Alkyl) oder $-\!\!\left[CH_2CH_2O\right]_m\!-C_6H_4$-($C_7$—$C_{10}$-Alkyl) ist, worin m ein Wert von 2—20 ist, und $R^2$ $C_1$—$C_4$-Alkyl ist oder die für $R^1$ gegebene Bedeutung hat oder b)

$R^1$ und $R^2$ dieselbe Bedeutung haben und je einen $C_9$—$C_{16}$-Alkylrest darstellen.

9. Verbindung gemäss Anspruch 8 der Formel I, worin $Ar^1$ und $Ar^2$ unabhängig voneinander Phenyl oder durch $C_1$—$C_4$-Alkyl oder Halogen substituiertes Phenyl sind und $R^1$ und $R^2$ dieselbe Bedeutung haben und je einen $C_{12}$—$C_{16}$-Alkylrest darstellen.

10. Photohärtbare Zusammensetzung, enthaltend mindestens eine ethylenisch ungesättigte Verbindung und 0.5 bis 20 Gew.% eines Initiatorgemisches gemäss Anspruch 1.

11. Photohärtbare Zusammensetzung gemäss Anspruch 10, dadurch gekennzeichnet, dass die Zusammensetzung ein Lack oder eine Druckfarbe ist.

12. Photohärtbare Zusammensetzung gemäss Anspruch 10, dadurch gekennzeichnet, dass die Zusammensetzung zur Herstellung von Druckplatten, Resistmaterialen, Bildaufzeichnungsmaterialien oder sonstigen Informationsträgern verwendet wird.

**Revendications**

1, Mélange liquide de photo-amorceurs constitué

A) de 70 à 99,9% en poids d'au moins un acétal photo-amorceur liquide pris dans l'ensemble constitué par:

$A_1$) les composés répondant à la formule I:

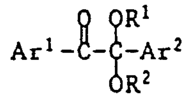

I

dans laquelle

$Ar^1$ et $Ar^2$ représentent chacun, indépendamment l'un de l'autre, un phényle ou un phényle porteur d'un alkyle en $C_1—C_4$ ou d'un halogène,

$R^1$ représente un alkyle en $C_4—C_{20}$, un alcényle en $C_3—C_{18}$, un phénylalkyle en $C_7—C_{10}$, un radical $—CH(R^3)—COOR^4$, un radical $—R^5—X$, un radical $-\!\![CH(R^3)—CH(R^{10})—O]_m\!\!—R^6$ ou un radical tétrahydrofurfuryle, radicaux dans lesquels

$R^3$ et $R^{10}$ représentent chacun, indépendamment l'un de l'autre, l'hydrogène ou un méthyle,

$R^4$ représente un alkyle en $C_1—C_{20}$, un alcényle en $C_3—C_5$ ou un alcoxyalkyle en $C_3—C_8$,

$R^5$ représente un alkylène en $C_2—C_{10}$,

X représente un halogène, un radical $—COOR^4$, un radical $—OR^4$ ou un radical $—NR^7R^8$, radicaux dans lesquels $R^7$ représente un alkyle en $C_1—C_{12}$, un allyle, un benzyle, un cyclohexyle, un hydroxyalkyle en $C_2—C_4$ ou un alcoxyalkyle en $C_3—C_8$, $R^8$ représente l'hydrogène ou a l'une des significations indiquées pour $R^7$, ou $R^7$ et $R^8$ forment ensemble un alkylène en $C_3—C_7$ qui peut être interrompu par O, S ou $NR^9$, le symbole $R^9$ désignant un alkyle en $C_1—C_4$, un hydroxyalkyle en $C_2—C_4$ ou un cyano-2 éthyle,

m désigne un nombre de 1 à 30 et

$R^6$ représente un alkyle en $C_1—C_{20}$, un alcényle en $C_3—C_5$, un alcoxyalkyle en $C_3—C_8$, un alkylphényle en $C_7—C_{22}$ ou un alcanoyle en $C_2—C_{20}$,

et

$R^2$ représente un alkyle en $C_1—C_3$ ou a l'une des significations qui ont été données pour $R^1$,

$A_2$) les composés répondant à la formule II:

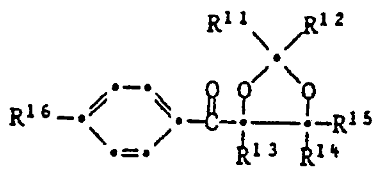

II

dans laquelle

$R^{11}$ représente l'hydrogène, un alkyle en $C_1—C_{10}$ non substitué ou porteur d'un hydroxy ou d'un alcoxy en $C_1—C_4$, ou un phénylalkyle en $C_7—C_{10}$,

$R^{12}$ représente un phényle, un furyle-2 ou un trichlorométhyle ou a l'une des significations qui ont été données pour $R^{11}$, ou encore

$R^{11}$ et $R^{12}$ forment ensemble, et avec l'atome de carbone auquel ils sont liés, un cycle de cyclopentane ou cyclohexane,

$R^{13}$ représente un alkyle en $C_1—C_4$, un phényle ou un phényle porteur d'un ou de plusieurs substituants pris dans l'ensemble constitué par Cl, les alkyles en $C_1—C_4$ et les alcoxy en $C_1—C_4$,

$R^{14}$ représente l'hydrogène ou un alkyle en $C_1—C_4$,

$R^{15}$ représente l'hydrogène, un alkyle en $C_1—C_4$, un phényle ou un trichlorométhyle et

$R^{16}$ représente l'hydrogène, le chlore, un alkyle en $C_1—C_4$ ou un alcoxy en $C_1—C_4$, et

$A_3$) les composés répondant à la formule III;

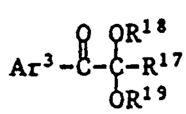

III

dans laquelle

$Ar^3$ représente un phényle ou un phényle porteur d'un alkyle en $C_1—C_4$ ou d'un halogène,

$R^{17}$ représente l'hydrogène, un alkyle en $C_1—C_8$ ou un cycloalkyle en $C_5—C_8$,

$R^{18}$ représente un alkyle en $C_1—C_8$ ou un alcoxyalkyle en $C_3—C_8$ et

$R^{19}$ a l'une des significations qui ont été données pour $R^{18}$,

et

B) de 0,1 à 30% en poids d'un titanocène photo-amorceur pris dans l'ensemble constitué par:
$B_1$) les composés répondant à la formule IV:

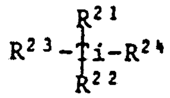

IV

dans laquelle
$R^{21}$ et $R^{22}$ représentent chacun, indépendamment l'un de l'autre, un anion cyclopentadiényle ou indényle non substitué ou porteur d'un alkyle en $C_1$—$C_4$, d'un chlore, d'un phényle ou d'un cyclohexyle ou forment ensemble un anion bis-cyclopentadiényle bivalent répondant à la formule V:

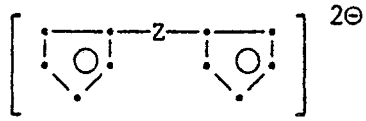

V

dans laquelle Z représente un méthylène, un diméthylène, un triméthylène, un alkylidène en $C_2$—$C_{12}$, un cyclo-alkylidène en $C_5$—$C_7$, un radical —Si($R^{25}$)($R^{26}$)— ou un radical —Sn($R^{25}$)$_2$—, les symboles $R^{25}$ et $R^{26}$ représentant chacun un alkyle en $C_1$—$C_{12}$, un phényle ou un benzyle,
$R^{23}$ représente le radical univalent d'un cycle aromatique carbocyclique à 6 maillons ou hétérocyclique à 5 ou 6 maillons, qui porte du fluor en au moins une position ortho par rapport à la liaison à l'atome de titane et qui peut en outre porter un ou plusieurs substituants pris dans l'ensemble constitué par les halogènes, les alkyles en $C_1$—$C_{12}$, les alcoxy en $C_1$—$C_{14}$, les alcoxycarbonyles en $C_2$—$C_{10}$ et les amino-carbonyles à au plus 12 atomes de carbone ou porter un radical amino ou aminoalkyle primaire, secondaire ou tertiaire contenant au plus 20 atomes de carbone ou un radical ammonium ou ammonioalkyle quaternaire contenant au plus 30 atomes de carbone,
$R^{24}$ a l'une des significations qui ont été données pour $R^{23}$ ou représente un alcynyle en $C_2$—$C_{12}$, un phénylalcynyle contenant de 2 à 5 atomes de carbone dans la partie alcynyle, non substitué ou portant, sur le radical phényle, un halogène, un alkyle en $C_1$—$C_4$, un alcoxy en $C_1$—$C_4$, un di-($C_2$—$C_4$-alkyl)-amino ou un radical ammonium quaternaire, ou représente un radical —$N_3$, —CN, —Si($R^{25}$)$_3$, —Si($R^{25}$)$_2$($R^{26}$) ou —Sn($R^{25}$)$_3$, ou
$R^{23}$ et $R^{24}$ forment ensemble un radical répondant à la formule VI:

$$—Q—Y—Q— \qquad VI$$

dans laquelle Q représente un cycle aromatique carbocyclique ou hétérocyclique à 5 ou 6 maillons, qui est lié à l'atome de titane par sa position 2 relativement au radical Y, qui porte un atome de fluor en position 3 et qui peut porter, comme autres substituants, un alkyle en $C_1$—$C_4$, un halogène, un alcoxy en $C_1$—$C_4$, un di-($C_1$—$C_4$-alkyl)-amino ou un radical ammonium quaternaire en $C_3$—$C_{20}$, et Y représente un méthylène, un alkylidène en $C_2$—$C_{12}$, un cycloalkylidène en $C_5$—$C_7$, une liaison directe ou un radical —$NR^{27}$—, —O—, —S—, —SO—, —$SO_2$—, —CO—, —Si($R^{25}$)($R^{26}$)— ou —Sn($R^{25}$)$_2$—, le symbole $R^{27}$ désignant l'hydrogène, un alkyle en $C_1$—$C_{12}$, un cyclohexyle, un phényle, un tolyle ou un benzyle,
et
$B_2$) les composés répondant à la formule VII:

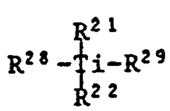

VII

dans laquelle
$R^{21}$ et $R^{22}$ ont les significations qui leur ont été données ci-dessus,
$R^{28}$ représente le radical univalent d'un cycle aromatique carbocyclique à 6 maillons ou hetérocyclique à 5 ou 6 maillons, qui porte un radical —$CF_3$ en au moins une des positions ortho par rapport à la liaison à l'atome de titane et qui peut en outre porter un ou plusieurs substituants pris dans l'ensemble constitué par les halogènes, les alkyles en $C_1$—$C_{12}$, les alcoxy en $C_1$—$C_{14}$, les alcoxycarbonyles en $C_2$—$C_{10}$ et les amino-carbonyles, ou un radical amino ou amino-alkyle primaire, secondaire ou tertiaire contenant au plus 20 atomes de carbone, ou un radical ammonium ou ammonio-alkyle quaternaire contenant au plus 30 atomes de carbone, et
$R^{29}$ a l'une des significations qui ont été données pour $R^{28}$ ou représente un alcynyle en $C_2$—$C_{12}$, un phénylalcynyle non substitué ou portant, sur sa partie phényle, un halogène ou un alkyle en $C_1$—$C_4$, la partie alcynyle de ce phénylalcynyle contenant de 2 à 5 atomes de carbone, un halogène ou un radical

—$Si(R^{25})_3$, —$Si(R^{25})_2(R^{26})$, —$Sn(R^{25})_3$, —OH, un alcoxy en $C_1$—$C_{10}$, un aryloxy en $C_6$—$C_{10}$, un acyloxy en $C_1$—$C_6$ non substitué ou porteur d'un halogène, —$N_3$, —CN, —NCO ou —NCS.

2. Mélange liquide d'amorceurs selon la revendication 1 qui est constitué:

A) de 90 à 99,5% en poids d'au moins un composé liquide de formule I, II ou III et

B) de 0,5 à 10% en poids d'un titanocène de formule IV ou VII.

3. Mélange liquide d'amorceurs selon la revendication 1 caractérisé en ce que la composante A) est soit

$A_1$) un benzile-acétal liquide de formule I dans lequel:

$Ar^1$ et $Ar^2$ représentent chacun un radical phényle, tolyle, chlorophényle ou bromophényle,

$R^1$ représente un alkyle en $C_4$—$C_{18}$, un alcényle en $C_3$—$C_5$, un radical —$CH_2COOR^4$, un radical —$R_5$—X, un radical $-\!\!\!+\!CH(R^3)—CH_2—O\,\}_m R^6$ ou un radical tétrahydrofurfuryle, radicaux dans lesquels $R^3$ représente H ou $CH_3$, $R^4$ un alkyle en $C_1$—$C_{18}$, un allyle ou un alcoxyalkyle en $C_3$—$C_6$, $R^5$ un alkylène en $C_2$—$C_4$, X un halogène, un radical —$COOR^4$ ou —$OR^4$ ou un radical amino tertiaire contenant de 2 à 12 atomes de carbone, m un nombre de 1 à 25 et $R^6$ un alkyle en $C_1$—$C_{18}$ ou un alkylphényle en $C_{12}$—$C_{22}$, et

$R^2$ représente un méthyle ou a l'une des significations qui ont été données pour $R^1$,

soit

$A_2$) un dioxolanne liquide de formule II dans lequel

$R^{11}$ représente l'hydrogène, un alkyle en $C_1$—$C_5$, un alcoxyalkyle en $C_2$—$C_8$, un hydroxyalkyle en $C_2$—$C_4$ ou un benzyle,

$R^{12}$ représente un phényle ou un furyle-2 ou a l'une des significations qui ont été données pour $R^{11}$, ou encore $R^{11}$ et $R^{12}$ forment ensemble, et avec l'atome de carbone auquel ils sont liés, un cycle de cyclopentane ou de cyclohexane,

$R^{13}$ représente un alkyle en $C_1$—$C_4$ ou un phényle,

$R^{14}$ représente l'hydrogène ou un alkyle en $C_1$—$C_4$,

$R^{15}$ représente l'hydrogène, un alkyle en $C_1$—$C_4$ ou un phényle et

$R^{16}$ représente l'hydrogène, le chlore, un méthyle ou un méthoxy,

soit

$A_3$) un acétal liquide de formule III dans lequel $Ar^3$ représente un phényle, $R^{17}$ l'hydrogène et $R^{18}$ et $R^{19}$ chacun un alkyle en $C_1$—$C_4$,

et la composante B est un titanocène de formule IV dans lequel:

$R^{21}$ et $R^{22}$ représentent chacun un anion cyclopentadiényle non substitué ou porteur d'un alkyle en $C_1$—$C_4$ et

$R^{23}$ et $R^{24}$ représentent chacun un radical répondant à la formule VIII

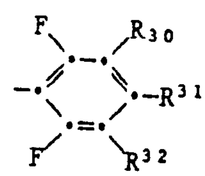

VIII

dans laquelle $R^{30}$, $R^{31}$ et $R^{32}$ représentent chacun, indépendamment les uns des autres, l'hydrogène, F, Cl, Br, un alcoxy en $C_1$—$C_4$, un radical amino ou aminométhyle tertiaire contenant de 2 à 20 atomes carbone ou un radical ammonium ou ammoniométhyle quaternaire contenant de 3 à 24 atomes de carbone,

$R^{23}$ et $R^{24}$ forment ensemble un radical bivalent de formule

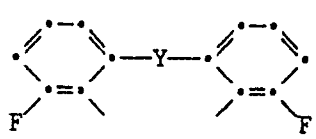

dans lequel Y a la signification indiquée à la revendication 1,

ou la composante B est un titanocène de formule VII dans lequel:

$R^{21}$ et $R^{22}$ représentent chacun un anion cyclopentadiényle non substitué ou porteur d'un alkyle en $C_1$—$C_4$,

$R^{28}$ représente un radical répondant à la formule IX:

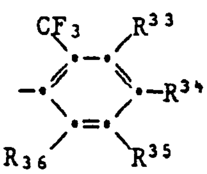

IX

dans laquelle $R^{33}$, $R^{34}$, $R^{35}$ et $R^{36}$ représentent chacun, indépendamment les uns des autres, l'hydrogène, F, Cl, Br ou un alcoxy en $C_1$—$C_{14}$, et

$R^{29}$ a l'une des significations qui ont été données pour $R^{28}$ ou représente F, Cl, Br, CN, $N_3$, un acyloxy en $C_2$—$C_4$ non substitué ou porteur d'un halogène, —NCO ou —NCS.

4. Mélange liquide d'amorceurs selon la revendication 1 caractérisé en ce que la composante A est soit un composé ou un mélange technique de composés de formule I dans lesquels $Ar^1$ et $Ar^2$ représentent chacun un phényle, $R^1$ représente un alkyle en $C_4$—$C_{16}$, un radical —$CH_2$—COO($C_1$—$C_4$-alkyl), un radical —$CH_2CH_2X$ ou $-\!\!(CH_2CH_2O)_{\overline{m}}R^6$, où X représente le chlore, un alcoxy en $C_1$—$C_8$ ou un radical amino tertiaire contenant de 2 à 8 atomes de carbone, m un nombre de 2 à 20 et $R^6$ un alkyle en $C_8$—$C_{16}$ ou un alkylphényle en $C_{13}$—$C_{16}$, et $R^2$ représente un méthyle ou a l'une des significations qui ont été données pour $R^1$, soit un composé de formule II dans lequel $R^{11}$ et $R^{12}$ représentent un méthyle ou forment ensemble, et avec l'atome de carbone auquel ils sont liés, un cycle de cyclopentane ou de cyclohexane, $R^{13}$ représente un méthyle ou un phényle, $R^{14}$ représente H ou un méthyle, $R^{15}$ représente H, un méthyle ou un phényle, et $R^{16}$ représente H, un méthyle ou un méthoxy, ou la composante A est la diméthoxy-2,2 acétophénone ou la diéthoxy-2,2 acétophénone.

5. Mélange liquide d'amorceurs selon la revendication 4 caractérisé en ce que la composante A est un composé ou un mélange technique de composés de formule I.

6. Mélange liquide d'amorceurs selon la revendication 5 caractérisé en ce que la composante A est un composé de formule I, ou un mélange technique de composés de formule I, dans lequel $R^1$ et $R^2$ représentent chacun un radical $-\!\!(CH_2CH_2O)_{\overline{m}}R^6$ dans lequel m désigne un nombre de 2 à 12 et $R^6$ représente un alkyle en $C_8$—$C_{16}$ ou un alkylphényle en $C_{13}$—$C_{16}$.

7. Mélange liquide d'amorceurs selon la revendication 3 caractérisé en ce que la composante B est soit un composé de formule IV dans lequel $R^{21}$ et $R^{22}$ représentent chacun un anion cyclopentadiényle ou méthylcyclopentadiényle, et $R^{23}$ et $R^{24}$ représentent chacun un radical de formule VIII dans lequel ou bien a) $R^{30}$ représente H, F, Cl ou Br, $R^{31}$ le fluor ou un alcoxy en $C_1$—$C_{14}$ et $R^{32}$ H, Cl ou Br, ou bien b) $R^{30}$ et $R^{32}$ représentent chacun H, F, Cl ou Br et $R^{31}$ représente H, Cl, Br, un alcoxy en $C_1$—$C_{14}$, un radical amino ou aminoéthyle tertiaire ou un radical ammonium ou ammoniométhyle quaternaire, soit un composé de formule VII dans lequel $R^{21}$ et $R^{22}$ représentent chacun un anion cyclopentadiényle ou méthylcyclopentadiényle, $R^{28}$ représente un radical trifluorométhyl-2 phényle ou fluoro-6 trifluorométhyl-2 phényle et $R^{29}$ a la même signification que $R^{28}$ ou représente F, Cl, Br, CN, $N_3$, —O—CO—$CH_3$, —O—CO—$CF_3$, —NCO ou NCS.

8. Composé répondant à la formule I

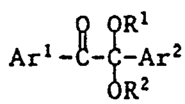

I

dans laquelle $Ar^1$ et $Ar^2$ représentent chacun, indépendamment l'un de l'autre, un phényle ou un phényle porteur d'un alkyle en $C_1$—$C_4$ ou d'un halogène, et a) $R^1$ représente un radical $-\!\!(CH_2CH_2O)_{\overline{m}}$ ($C_8$—$C_{16}$-alkyl) ou un radical $-\!\!(CH_2CH_2O)_{\overline{m}}C_6H_4$—($C_7$—$C_{10}$-alkyl), radicaux dans lesquels m désigne un nombre de 2 à 20, et $R^2$ représente un alkyle en $C_1$—$C_4$ ou a la signification qui a été donnée pour $R^1$, ou b) $R^1$ et $R^2$ ont la même signification et représentent chacun un radical alkyle en $C_9$—$C_{16}$.

9. Composé de formule I selon la revendication 8 dans lequel $Ar^1$ et $Ar^2$ représentent chacun, indépendamment l'un de l'autre, un phényle ou un phényle porteur d'un alkyle en $C_1$—$C_4$ ou d'un halogène, et $R^1$ et $R^2$ ont la même signification et représentent chacun un alkyle en $C_{12}$—$C_{16}$.

10. Composition photodurcissable qui contient au moins un composé éthylénique et de 0,5 à 20% en poids d'un mélange d'amorceurs selon la revendication 1.

11. Composition photodurcissable selon la revendication 10 caractérisée en ce qu'elle est un vernis ou une encre d'imprimerie.

12. Composition photodurcissable selon la revendication 10 caractérisée en ce qu'elle est utilisée pour la fabrication de clichés d'imprimerie, de matières pour résistes (réserves), de matières pour l'enregistrement d'images ou d'autres supports d'informations.

**Claims**

1. A liquid photoinitiator mixture consisting of

A) 70—99.9% by weight of at least one liquid acetal or ketal photoinitiator selected from

$A_1$) a compound of the formula I

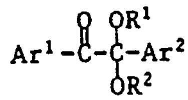

I

in which

$Ar^1$ and $Ar^2$ are independently of each other phenyl or $C_1$—$C_4$alkyl- or halogen-substituted phenyl,

$R^1$ is $C_4$—$C_{20}$alkyl, $C_3$—$C_{18}$alkenyl, $C_7$—$C_{10}$phenylalkyl, a group —CH($R^3$)—COOR$^4$, —$R^5$—X, $-[CH(R^3)-CH(R^{10})-O]_m-R^6$ or tetrahydrofurfuryl, in which

$R^3$ and $R^{10}$ are independently of each other hydrogen or methyl,

$R^4$ is $C_1$—$C_{20}$alkyl, $C_3$—$C_5$alkenyl or $C_3$—$C_8$alkoxyalkyl,

$R^5$ is $C_2$—$C_{10}$alkylene,

X is halogen, —COOR$^4$, —OR$^4$ or —NR$^7$R$^8$, where $R^7$ is $C_1$—$C_{12}$alkyl, allyl, benzyl, cyclohexyl, $C_2$—$C_4$hydroxyalkyl or $C_3$—$C_8$alkoxyalkyl, $R^8$ is hydrogen or has one of the meanings given for $R^7$, or $R^7$ and $R^8$ together are $C_3$—$C_7$-alkylene which can be interrupted by O, S or NR$^9$ and $R^9$ is $C_1$—$C_4$alkyl, $C_2$—$C_4$hydroxyalkyl or 2-cyanoethyl,

m is from 1 to 30 and

$R^6$ is $C_1$—$C_{20}$alkyl, $C_3$—$C_5$alkenyl, $C_3$—$C_8$alkoxyalkyl, $C_7$—$C_{22}$alkylphenyl or $C_2$—$C_{20}$alkanoyl, and

$R^2$ is $C_1$—$C_3$alkyl or has one of the meanings given for $R^1$ or

$A_2$) a compound of the formula II

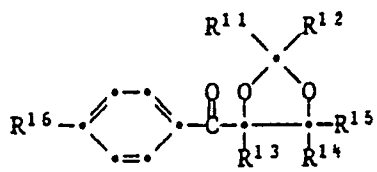

II

in which

$R^{11}$ is hydrogen, unsubstituted- or hydroxyl- or $C_1$—$C_4$alkoxy-substituted $C_1$—$C_{10}$alkyl or $C_7$—$C_{10}$phenylalkyl,

$R^{12}$ is phenyl, 2-furyl or trichloromethyl or has one of the meanings given for $R^{11}$, or $R^{11}$ and $R^{12}$ together with the C atom to which they are bonded form a cyclopentane or cyclohexane ring,

$R^{13}$ is $C_1$—$C_4$alkyl, phenyl or Cl-, $C_1$—$C_4$alkyl or $C_1$—$C_4$alkoxy-monosubstituted or -polysubstituted phenyl,

$R^{14}$ is hydrogen or $C_1$—$C_4$alkyl,

$R^{15}$ is hydrogen, $C_1$—$C_4$alkyl, phenyl or trichloromethyl,

$R^{16}$ is hydrogen, chlorine, $C_1$—$C_4$alkyl or $C_1$—$C_4$alkoxy, or

$A_3$) a compound of the formula III,

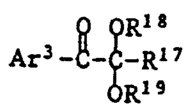

III

in which

$Ar^3$ is phenyl or $C_1$—$C_4$alkyl- or halogen-substituted phenyl,

$R^{17}$ is hydrogen, $C_1$—$C_8$-alkyl or $C_5$—$C_8$cycloalkyl,

$R^{18}$ is $C_1$—$C_8$alkyl or $C_3$—$C_8$alkoxyalkyl and

$R^{19}$ has one of the meanings given for $R^{18}$, and

B) 0.1—30% by weight of a titanocene photoinitiator selected from

$B_1$) a compound of the formula IV

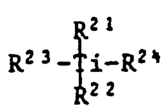

IV

in which $R^{21}$ and $R^{22}$ are independently of each other an unsubstituted or $C_1$—$C_4$alkyl-, chlorine-, phenyl- or cyclohexyl-substituted cyclopentadienyl or indenyl anion or $R^{21}$ and $R^{22}$ together are a divalent biscyclopentadienyl anion of the formula V,

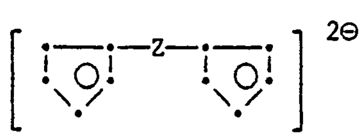

V

in which Z is methylene, dimethylene, trimethylene, $C_2$—$C_{12}$alkylidene, $C_5$—$C_7$cycloalkylidene, —Si($R^{25}$)($R^{26}$)— or —Sn($R^{25}$)$_2$— and $R^{25}$ and $R^{26}$ are $C_1$—$C_{12}$alkyl, phenyl or benzyl,

$R^{23}$ is the monovalent radical of a 6-membered carbocyclic or 5- or 6-membered heterocyclic aromatic ring which is substituted in at least one ortho-position relative to the bond to the Ti atom by fluorine and also by one or more of the groups halogen, $C_1$—$C_{12}$alkyl, $C_1$—$C_{14}$alkoxy, $C_2$—$C_{10}$-alkoxycarbonyl, aminocarbonyl of up to 12 carbon atoms or by a primary, secondary or tertiary amino or aminoalkyl group having up to 20 carbon atoms or a quaternary ammonium or ammoniumalkyl group having up to 30 C atoms,

$R^{24}$ has one of the meanings given for $R^{23}$ or is $C_2$—$C_{12}$alkynyl, phenylalkynyl having 2—5 C atoms in the alkynyl radical and is unsubstituted or substituted in the phenyl radical by halogen or $C_1$—$C_4$alkyl, $C_1$—$C_{14}$alkoxy, di-($C_2$—$C_4$alkyl)-amino or a quaternary ammonium group, or is a group —$N_3$—, —CN, —$Si(R^{25})_3$, —$Si(R^{25})_2(R^{26})$ or —$Sn(R^{25})_3$, or $R^{23}$ and $R^{24}$ together are a radical of the formula VI

$$—Q—Y—Q— \qquad \text{VI}$$

in which Q is a carbocyclic or 5- or 6-membered heterocyclic aromatic ring which in the 2-position relative to the Y group is bonded to the titanium atom and in the 3-position is substituted by fluorine and can contain as further substituents $C_1$—$C_4$alkyl, halogen, $C_1$—$C_4$alkoxy, di-($C_1$—$C_4$alkyl)amino or a quaternary $C_3$—$C_{20}$ammonium group,

Y is methylene, $C_2$—$C_{12}$alkylidene, $C_5$—$C_7$cycloalkylidene, a direct bond or a group —$NR^{27}$—, —O—, —S—, —SO—, $SO_2$, —CO—, —$Si(R^{25})(R^{26})$— or —$Sn(R^{25})_2$— and $R^{27}$ is hydrogen, $C_1$—$C_{12}$alkyl, cyclohexyl, phenyl, tolyl or benzyl, or

$B_2$) a compound of the formula VII

$$R^{28}-\underset{R^{22}}{\overset{R^{21}}{Ti}}-R^{29} \qquad \text{VII}$$

in which $R^{21}$ and $R^{22}$ are as defined above,

$R^{28}$ is the monovalent radical of a 6-membered carbocyclic or 5- or 6-membered heterocyclic aromatic ring which is substituted in at least one ortho-position relative to the bond to the Ti atom by —$CF_3$ and can additionally be substituted by one or more of the groups halogen, $C_1$—$C_{12}$alkyl, $C_1$—$C_{14}$alkoxy, $C_2$—$C_{10}$alkoxycarbonyl or aminocarbonyl or by a primary, secondary or tertiary amino or aminoalkyl group having up to 20 C atoms or a quaternary ammonium or ammoniumalkyl group having up to 30 C atoms and

$R^{29}$ has one of the meanings given for $R^{28}$ or is $C_2$—$C_{12}$alkynyl, phenylalkynyl having 2—5 C atoms in the alkynyl radical which is unsubstituted or substituted in the phenyl radical by halogen or $C_1$—$C_4$alkyl, or is halogen or a group —$Si(R^{25})_3$, —$Si(R^{25})_2(R^{26})$, —$Sn(R^{25})_3$, —OH, $C_1$—$C_{10}$alkoxy, $C_6$—$C_{10}$aryloxy, unsubstituted or halogen-substituted $C_1$—$C_6$acyloxy, —$N_3$, —CN, —NCO or —NCS.

2. A liquid initiator mixture according to claim 1 consisting of

A) 90—99.5% by weight of at least one liquid compound of the formula I, II or III and

B) 0.5—10% by weight of a titanocene compound of the formula IV or VII.

3. A liquid initiator mixture according to claim 1 wherein component A) is either

$A_1$) a liquid benzil ketal of the formula I in which

$Ar^1$ and $Ar^2$ are phenyl, tolyl, chlorophenyl or bromophenyl,

$R^1$ is $C_4$—$C_{18}$alkyl, $C_3$—$C_5$alkenyl, —$CH_2COOR^4$, —$R^5$—X, $\left[CH(R^3)—CH_2O\right]_m R^6$ or tetrahydrofurfuryl, in which $R^3$ is H or $CH_3$,

$R^4$ is $C_1$—$C_{18}$alkyl, allyl or $C_3$—$C_6$alkoxyalkyl, $R^5$ is $C_2$—$C_4$alkylene, X is halogen, —$COOR^4$, —$OR^4$ or a tertiary amino group having 2—12 C atoms,

m is 1—25 and $R^6$ is $C_1$—$C_{18}$alkyl or $C_{12}$—$C_{22}$alkylphenyl, and

$R^2$ is methyl or has one of the meanings given for $R^1$, or

$A_2$) is a liquid dioxolane of the formula II in which

$R^{11}$ is hydrogen, $C_1$—$C_5$alkyl, $C_2$—$C_8$alkoxyalkyl, $C_2$—$C_4$hydroxyalkyl or benzyl, $R^{12}$ is phenyl or 2-furyl or has one of the meanings given for $R^{11}$, or $R^{11}$ and $R^{12}$ together with the C atom to which they are bonded form a cyclopentane or cyclohexane ring,

$R^{13}$ is $C_1$—$C_4$alkyl or phenyl,

$R^{14}$ is hydrogen or $C_1$—$C_4$ alkyl,

$R^{15}$ is hydrogen, $C_1$—$C_4$alkyl or phenyl, and

$R^{16}$ is hydrogen, chlorine, methyl or methoxy, or

$A_3$) is a liquid acetal or ketal of the formula III in which $Ar^3$ is phenyl,

$R^{17}$ is hydrogen and $R^{18}$ and $R^{19}$ are $C_1$—$C_4$alkyl, and component B is a titanocene compound of the formula IV in which $R^{21}$ and $R^{22}$ are an unsubstituted or $C_1$—$C_4$alkyl-substituted cyclopentadienyl anion and

$R^{23}$ and $R^{24}$ are a group of the formula VIII

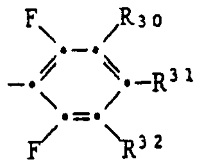

VIII

in which $R^{30}$, $R^{31}$ and $R^{32}$ are independently of one another hydrogen, F, Cl, Br, $C_1$—$C_{14}$alkoxy, a tertiary amino group or aminomethyl group having 2—20 C atoms or a quaternary ammonium or ammoniummethyl group having 3—24 C atoms or $R^{23}$ and $R^{24}$ together are a divalent group of the formula

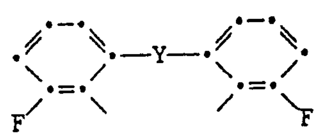

in which Y has the meaning given in claim 1, or component B is a titanocene compound of the formula VII in which $R^{21}$ and $R^{22}$ are an unsubstituted or $C_1$—$C_4$alkyl-substituted cyclopentadienyl anion and $R^{28}$ is a group of the formula IX

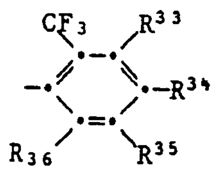

IX

in which $R^{33}$, $R^{34}$ and $R^{36}$ are independently of one another hydrogen, F, Cl, Br or $C_1$—$C_{14}$alkoxy and $R^{29}$ has one of the meanings given for $R^{28}$ or is F, Cl, Br, CN, $N_3$, unsubstituted or halogen-substituted $C_2$—$C_4$acyloxy, —NCO or —NCS.

4. A liquid initiator mixture according to claim 1, wherein component A is either a compound or a technical-grade mixture of compounds of the formula I in which $Ar^1$ and $Ar^2$ are phenyl, $R^1$ is $C_4$—$C_{16}$alkyl, —$CH_2$—COO($C_1$—$C_4$alkyl), —$CH_2CH_2X$ or $-(CH_2CH_2O)_m-R^6$, in which X is chlorine, $C_1$—$C_8$alkoxy or a tertiary amino group having 2—8 C atoms, m is a value from 2 to 20, $R^6$ is $C_8$—$C_{16}$alkyl or $C_{13}$—$C_{16}$alkylphenyl, $R^2$ is methyl or has one of the meanings given for $R^1$, or is a compound of the formula II in which $R^{11}$ and $R^{12}$ are methyl or together with the C atom to which they are bonded form a cyclopentane or cyclohexane ring, $R^{13}$ is methyl or phenyl, $R^{14}$ is H or methyl, $R^{15}$ is H, methyl or phenyl and $R^{16}$ is H, methyl or methoxy, or in which component A is 2,2-dimethoxyacetophenone or 2,2-diethoxyacetophenone.

5. A liquid initiator mixture according to claim 4, wherein component A is a compound or a technical-grade mixture of compounds of the formula I.

6. A liquid initiator mixture according to claim 5, wherein component A is a compound or a technical-grade mixture of the formula I in which $R^1$ and $R^2$ are $-(CH_2CH_2O)_m-R^6$, in which m is a value from 2—12 and $R^6$ is $C_8$—$C_{18}$alkyl or $C_{13}$—$C_{16}$alkylphenyl.

7. A liquid initiator mixture according to claim 3, wherein component B is either a compound of the formula IV in which $R^{21}$ and $R^{22}$ are a cyclopentadienyl or methylcyclopentadienyl anion and $R^{23}$ and $R^{24}$ are a group of the formula VIII in which either a) $R^{30}$ is H, F, Cl or Br, $R^{31}$ is fluorine or $C_1$—$C_4$alkoxy and $R^{32}$ is H, Cl or Br or b) $R^{30}$ and $R^{32}$ are H, F, Cl or Br and $R^{31}$ is H, Cl, Br, $C_1$—$C_{14}$alkoxy, a tertiary amino or aminomethyl group or a quaternary ammonium or ammoniummethyl group, or B is a compound of the formula VII in which $R^{21}$ and $R^{22}$ are a cyclopentadienyl or methylcyclopentadienyl anion, $R^{28}$ is 2-(trifluoromethyl)phenyl or 6-fluoro-2-(trifluoromethyl)phenyl and $R^{29}$ is defined in the same way as $R^{28}$ or is F, Cl, Br, CN, $N_3$, —O—CO—$CH_3$, —O—CO—$CF_3$, —NCO or —NCS.

8. A compound of the formula I

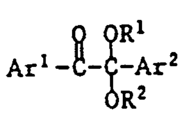

I

in which $Ar^1$ and $Ar^2$ are independently or each other phenyl or $C_1$—$C_4$alkyl- or halogen-substituted phenyl, and a) $R^1$ is a group of the formula $-(CH_2CH_2O)_m-$($C_8$—$C_{16}$)alkyl or $-(CH_2CH_2O)_m-C_6H_4$—($C_7C_{10}$alkyl), in which m is a value from 2—20, and $R^2$ is $C_1$—$C_4$alkyl or has the meaning given for $R^1$ or b) $R^1$ and $R^2$ have the same meaning and are each a $C_9$—$C_{16}$alkyl radical.

9. A compound according to claim 8 of the formula I in which $Ar^1$ and $Ar^2$ are independently of each other phenyl or $C_1$—$C_4$alkyl- or halogen-substituted phenyl and $R^1$ and $R^2$ have the same meaning and each is a $C_{12}$—$C_{16}$alkyl radical.

10. A photocurable composition containing at least one ethylenically unsaturated compound and 0.5 to 20% by weight of an initiator mixture according to claim 1.

11. A photocurable composition according to claim 10, wherein the composition is a surface coating or printing ink.

12. A photocurable composition according to claim 10, wherein the composition is used for preparing printing plates, resist materials, image-recording materials or other kinds of information carriers.